# EUROPEAN PATENT APPLICATION

(11) **EP 4 679 985 A1**
(43) Date of publication of application: **14.01.2026**
(21) Application number: 24767247.0
(22) Date of filing: 08.03.2024
(51) Int. Cl.: H10K 30/50, H10K 30/40, H10K 30/81

(54) **PHOTOELECTRIC CONVERSION ELEMENT AND SOLAR CELL COMPRISING SAME**

(30) Priority: 09.03.2023 JP 2023036319
(71) Applicant: Citizen Watch Co., Ltd., Nishitokyo-shi, Tokyo 188-8511 (JP)
(72) Inventor: NAKAGAWA, Akira, Nishitokyo-shi, Tokyo 188-8511 (JP)
(74) Representative: Hoffmann Eitle
(86) International application number: PCT/JP2024/008990
(87) International publication number: WO 2024/185882

(57) **Abstract**

A photoelectric conversion element (1,2) has a transparent electroconductive layer (11), a hole transport layer (12), a light absorption layer (13), an electron transport layer (14), and an electrode (15) stacked in this order; the light absorption layer (13) containing a material that contains a halide ion, and the electrode (15) having a Bi layer (151), a Ti layer or a Cr layer (152), and an Au layer (153) stacked in this order when viewed from the electron transport layer (14). The material contained in the light absorption layer (13) is preferred to further contain silver ion and bismuth ion.

## Description

### Field

The present invention relates to a photoelectric conversion element, and a solar cell having the same.

### Background

Non Patent Literatures 1 to 3 describe solar cells with inverted structures. Non Patent Literature 1 uses a Bi electrode and a Bi/Ag electrode as the electrode (negative electrode) and uses methyl ammonium lead iodide (MAPbI₃) for the light absorption layer. Non Patent Literature 2 uses a Ti/Au electrode as the electrode (negative electrode) and uses methyl ammonium lead iodide (MAPbI₃) for the light absorption layer. Non Patent Literature 3 uses an Au electrode as the electrode (negative electrode) and uses silver bismuth iodide (Ag₃BiI₆) for the light absorption layer.

### Citation List

### Non Patent Literature

Non Patent Literature 1: Shaohang Wu et al., "A chemically inert bismuth interlayer enhances long-term stability of inverted perovskite solar cells", NATURE COMMUNICATIONS, 10:1161 https://doi.org/10.1038/s41467-019-09167-0
Non Patent Literature 2: Tongfe Shi et al., "Ti/Au Cathode for Electronic transport material-free organic-inorganic hybrid perovskite solar cells", Scientific Reports, 6:39132, DOI:10.1038/srep39132
Non Patent Literature 3: Yejin Seo et al., "Dynamic casting in combination with ramped annealing process for implementation of inverted planar Ag3BiI6 rudorffite solar cells", Journal of Power Sources, 453 (2020), 227903

### Summary

### Technical Problem

However, these solar cells have room for improvement of conversion efficiency and stability.

It is, therefore, an object of the present invention to provide a photoelectric conversion element that excels in conversion efficiency, and can be used stably for a long term.

### Solution to Problem

A photoelectric conversion element according to the present invention includes a transparent electroconductive layer; a hole transport layer; a light absorption layer; an electron transport layer; and an electrode, wherein the transparent electroconductive layer, the hole transport layer, the light absorption layer, the electron transport layer, and the electrode being stacked in this order, the light absorption layer contains a material that contains a halide ion, the electrode has a first electroconductive layer, a second electroconductive layer, and a third electroconductive layer stacked in this order when viewed from the electron transport layer, the first electroconductive layer is structured to make ohmic contact with the electron transport layer, and to prevent the diffusion of the halide ions towards the second electroconductive layer, the second electroconductive layer is structured to prevent the diffusion of the third electroconductive layer towards the electron transport layer or the light absorption layer, and the third electroconductive layer is less reactive with oxygen or the halide ion, than the second electroconductive layer is.

A photoelectric conversion element according to the present invention includes a transparent electroconductive layer; a hole transport layer; a light absorption layer; an electron transport layer, and an electrode, wherein the transparent electroconductive layer, the hole transport layer, the light absorption layer, the electron transport layer, and the electrode being stacked in this order, the light absorption layer contains a material that contains a halide ion, and the electrode has a Bi layer, a Ti layer or a Cr layer, and an Au layer stacked in this order when viewed from the electron transport layer.

### Advantageous Effects of Invention

The photoelectric conversion element of the present invention has high conversion efficiency, and may be stably used for a long term.

### Brief Description of Drawings

FIG. 1 is a plan view of a photoelectric conversion element according to a first embodiment.
FIG. 2 is a cross-sectional view taken along line A-A' in FIG. 1.
FIG. 3 is a plan view of a photoelectric conversion element according to a second embodiment.
FIG. 4 is a cross-sectional view taken along line B-B' in FIG. 3.
FIG. 5A is a diagram illustrating a measured result of current-voltage characteristic of a photoelectric conversion element in Comparative Example 1.
FIG. 5B is a diagram illustrating a measured result of current-voltage characteristic of a photoelectric conversion element in Comparative Example 1.
FIG. 6 is a diagram illustrating a measured result of current-voltage characteristic of a photoelectric conversion element in Comparative Example 2.
FIG. 7 is a diagram illustrating a measured result of current-voltage characteristic of a photoelectric conversion element in Comparative Example 3.
FIG. 8 is a diagram illustrating a measured result of current-voltage characteristic of a photoelectric conversion element in Reference Example 2.
FIG. 9 is a diagram illustrating a measured result of current-voltage characteristic of a photoelectric conversion element in Reference Example 3.
FIG. 10 is a diagram illustrating a measured result of current-voltage characteristic of a photoelectric conversion element 1 in Example 1.
FIG. 11A is a diagram illustrating measured results of current-voltage characteristic of a photoelectric conversion element 1 in Example 2.
FIG. 11B is a diagram illustrating changes over time in conversion efficiency of the photoelectric conversion element 1 in Example 2.
FIG. 12A is a diagram illustrating a measured result of current-voltage characteristic of a photoelectric conversion element in Comparative Example 4.
FIG. 12B is a diagram illustrating changes over time in conversion efficiency of the photoelectric conversion element in Comparative Example 4.
FIG. 13 is a diagram illustrating measured results of current-voltage characteristic of a photoelectric conversion element 1 in Example 3.
FIG. 14 is a diagram illustrating measured results of current-voltage characteristic of a photoelectric conversion element 1 in Example 4.
FIG. 15 is a diagram illustrating measured results of current-voltage characteristic of a photoelectric conversion element 1 in Example 5.
FIG. 16 is a diagram illustrating measured results of current-voltage characteristic of a photoelectric conversion element 1 in Example 6.
FIG. 17 is a diagram illustrating measured results of current-voltage characteristic of a photoelectric conversion element 1 in Example 7.
FIG. 18A is a diagram illustrating a measured result of current-voltage characteristic of a photoelectric conversion element in Reference Example 4.
FIG. 18B is a diagram illustrating temporal changes in conversion efficiency of a photoelectric conversion element 1 in Example 7 and the photoelectric conversion element in Reference Example 4.
FIG. 19 is a diagram illustrating a measured result of current-voltage characteristic of a photoelectric conversion element in Reference Example 1.
FIG. 20 is a diagram 20 illustrating measured results of current-voltage characteristic of a photoelectric conversion element 1 in Example 8.
FIG. 21 is a diagram illustrating measured results of current-voltage characteristic of a photoelectric conversion element 1 in Example 9.
FIG. 22 is a diagram illustrating changes over time in conversion efficiency depending on measurement points, regarding the photoelectric conversion element 1 in Example 3, the photoelectric conversion element in Reference Example 4, and the photoelectric conversion element 1 in Example 7.
FIG. 23 is a diagram illustrating changes over time in conversion efficiency of the photoelectric conversion element 1 in Example 1, the photoelectric conversion element in Comparative Example 1, and the photoelectric conversion element 1 in Comparative Example 4.
FIG. 24A is a diagram illustrating a measured result of current-voltage characteristic of a photoelectric conversion element 1 in Example 10.
FIG. 24B is a diagram illustrating changes over time in conversion efficiency of the photoelectric conversion element 1 in Example 10.
FIG. 25A is a diagram illustrating a measured result of current-voltage characteristic of a photoelectric conversion element in Comparative Example 5.
FIG. 25B is a diagram illustrating changes over time in conversion efficiency of the photoelectric conversion element in Comparative Example 5.
FIG. 26 is a diagram illustrating measured results of current-voltage characteristic of a photoelectric conversion element 1 in Example 9.
FIG. 27 is a diagram illustrating measured results of current-voltage characteristic of a photoelectric conversion element in Example 11.
FIG. 28 is a diagram illustrating measured results of current-voltage characteristic of a photoelectric conversion element in Example 12.
FIG. 29 is a diagram illustrating changes over time in conversion efficiency of the photoelectric conversion element 1 in Example 9, the photoelectric conversion element in Example 11, and the photoelectric conversion element in Example 12.

### Description of Embodiments

Modes (embodiments) for carrying out the present invention will be detailed. The present invention is not limited by contents described in the embodiments below. Note that the constituents described below include those easily conceived by a person skilled in the art, or those that are substantially identical. Also note that structures described below may be appropriately combined. The structures may be omitted, replaced or modified in various ways, without departing from the gist of the present invention.

### <First Embodiment>

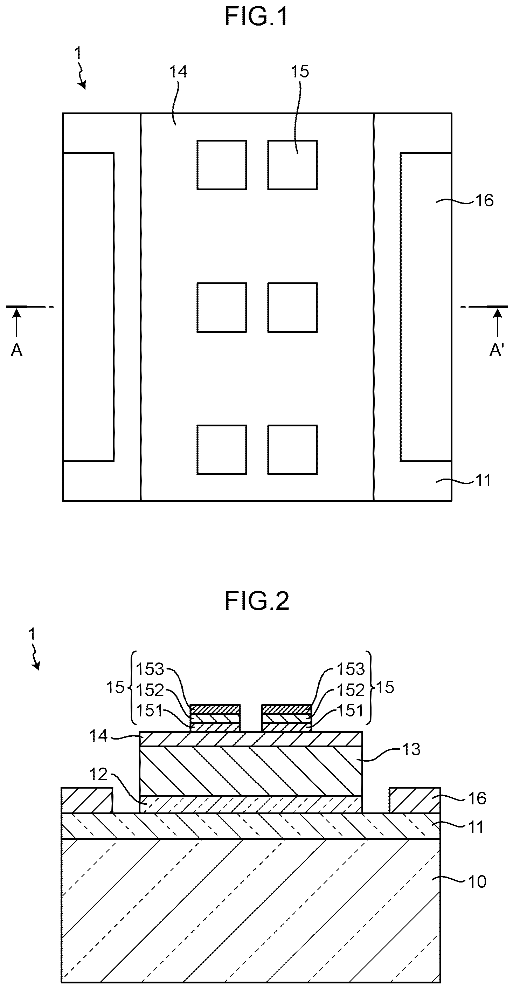

FIG. 1 is a plan view of a photoelectric conversion element according to a first embodiment, and FIG. 2 is a cross-sectional view taken along line A-A' in FIG. 1. A photoelectric conversion element 1 has a transparent electroconductive layer 11, a hole transport layer 12, a light absorption layer 13, an electron transport layer 14, and an electrode (upper electrode 15), all of which are stacked in this order on a transparent substrate 10. In addition, the photoelectric conversion element usually has a lower electrode 16. The photoelectric conversion element 1 is an inverted photoelectric conversion element structured that generates voltage between the lower electrode 16 and the upper electrode 15, and outputs current from the lower electrode 16, in response to light input through the substrate 10 and the transparent electroconductive layer 11.

The transparent substrate 10 capable of supporting the constituents contained in the photoelectric conversion element 1, and is formed of a transparent material (for example, insulating glass or the like) that allows an incident light on the photoelectric conversion element 1 to transmit therethrough, and on one face of which, the light to be absorbed by the light absorption layer 13 will be input. The transparent material causes transmission of light, whose wavelength is absorbable by the light absorption layer 13, and has a transmittance of light of 80% or larger, in a wavelength region absorbable by the light absorption layer 13. The material more preferably has a transmittance of light of 95% or larger, in a wavelength region absorbable by the light absorption layer 13. The transparent substrate 10 may also be formed of a conductive material or may be formed of a flexible synthetic resin such as polyimide, polyethylene naphthalate (PEN), or polyethylene terephthalate (PET). The transparent substrate 10 has a thickness of, for example, 0.1 mm or larger and 5.0 mm or smaller. The transparent substrate 10 may have, for example, a flat plate shape, a film-like sheet form, or a cylindrical sheet form.

The transparent electroconductive layer 11 is formed as a film with use of a low-resistance material that is transparent like the transparent substrate 10, and capable of transporting holes with high efficiency. The transparent electroconductive layer 11 is formed on the transparent substrate 10 so as to cover it, while opposing one face thereof to the other face of the transparent substrate 10. The transparent electroconductive layer 11 is a thin film, typically, having a smooth surface, being highly transparent, and having high electroconductivity formed of indium tin oxide (ITO). In a case where the transparent substrate 10 is formed of a material having low heat resistance such as polyimide, the transparent electroconductive layer 11 is formed of a material which can be formed by a low-temperature heat process, and being transparent and highly electroconductive. The material which can be formed by a low-temperature heat process, and being transparent and highly electroconductive is exemplified by aluminum-doped zinc oxide (AZO), gallium-doped zinc oxide (GZO), and niobium-doped titanium oxide (TNO). Alternatively, fluorine-doped tin oxide (FTO) less likely to change the resistivity due to high-temperature heat process may be used. The transparent electroconductive layer 11 preferably has a thickness of 0.01 µm or larger and 10.0 µm or smaller, and more preferably has a thickness of 0.05 µm or larger and 1.0 µm or smaller.

The hole transport layer 12 is a p-type semiconductor layer capable of blocking electrons generated in the light absorption layer 13, and of transporting holes generated in the light absorption layer 13 to the transparent electroconductive layer 11 with high efficiency. The hole transport layer 12 is formed on the transparent electroconductive layer 11 so as to cover it, while opposing one face thereof to the other face of the transparent electroconductive layer 11. The hole transport layer 12 is transparent and is formed of a material with high hole transport characteristic such as nickel oxide (NiOₓ). The hole transport layer 12 may alternatively be formed of oxide such as cuprous oxide (Cu₂O), copper oxide (CuO), or molybdenum oxide (MoO₃); or CuSCN. Moreover, the hole transport layer 12 is preferably formed of an organic material such as poly[bis(4-phenyl)(2,4,6-trimethylphenyl) amine] (PTAA), or a composite of poly(3,4-ethylenedioxythiophene) (PEDOT) and polystyrene sulfonic acid (PSS) (PEDOT:PSS), which is less soluble to a solvent used for forming a film of the light absorption layer 13.

Nickel oxide (NiOₓ) (0 < x ≤ 1) is a p-type semiconductor which is chemically stable, and in which Ni vacancies can function as acceptors without the addition of any impurity and is therefore applicable to a material for the hole transport layer 12. Zn-doped nickel oxide (NiO:Zn), to which impurities has been added, will have resistivity lowered from that of NiOₓ (0 < x ≤ 1), thus improving the hole transport characteristic. Content ratio of Ni and Zn (Ni:Zn) is preferably (99 at% to 80 at%): (1 at% to 20 at%). With the Zn content ratio exceeding 20 at%, it would cause the conversion efficiency of the photoelectric conversion element 1 to decrease. Setting the ratio of addition of Zn lower than 1 at% would fail to improve the hole transport characteristic. The hole transport layer 12 preferably has a thickness of 10 nm or larger and 300 nm or smaller. With the thickness of the hole transport layer 12 set smaller than 10 nm, the light absorption layer 13 would not be fully covered with the hole transport layer 12 on occasions. With the thickness of the hole transport layer 12 set larger than 300 nm, the resistance value between the transparent electroconductive layer 11 and the light absorption layer 13 would increase, thereby it would cause degrading the conversion efficiency of the photoelectric conversion element 1.

The light absorption layer 13 contains a material that contains a halide ion. As the material that contains a halide ion, a material further containing silver ion (Ag⁺) and bismuth ion (Bi³⁺) is preferably used. The halide ion is exemplified by F⁻, Cl⁻, Br⁻, and I⁻.

The material further containing silver ion and bismuth ion together with the halide ion is specifically exemplified by Ag/Bi-based material (also referred to as rudorffite material). The Ag/Bi-based material has a composition represented by AgₐBi_{b}X_{c}. X represents F, Cl, Br or I. Here, (a + 3b) × 0.8 ≤ c ≤ (a + 3b) ×1.2 holds. Combination (a,b) is exemplified by (1,1), (3,1), (1,3), (2,1), (7,1), (9,1), (5,1), (1,2), and (5,3). Note "a" and "b" accept errors ascribable to any defect or hetero-phase contained in the crystal. Among these, a material represented by AgₐBi_{b}I_{c} (a, b, and c represent composition ratios.) and satisfying c = a + 3b and 2 ≤ b/a ≤ 4 is more preferably used. The material further satisfying c = a + 3b and 2 ≤ b/a ≤ 2.5 is more preferred for use. The Ag/Bi-based materials may be used alone, or in combination of two or more species.

The material that contains a halide ion may alternatively be a material that contains Cu, Au, In, Na, K or NH₄ in place of Ag of the Ag/Bi-based material, and contains Sb, Ga, In, Tl or La in place of Bi of the Ag/Bi-based material.

The material that contains a halide ion may alternatively be organohalide lead perovskite compounds. The organohalide lead perovskite compounds are exemplified by those represented by (RNH₃)ₙPbI₍₂₊ₙ₎. Where, R represents a hydrocarbon group, and n is 1 or 2. Such compound is exemplified by (CH₃NH₃)PbI₃, (CH₃CH₂NH₃)PbI₃, (C₆H₅C₂H₄NH₃)₂PbI₄, (C₁₀H₇CH₃NH₃)₂PbI₄, and (C₄H₉C₂H₄NH₃)₂PbI₄. The organohalide lead perovskite compounds may be used alone, or in combination of two or more species.

The light absorption layer 13 preferably has a thickness of 10 nm or larger and 10000 nm or smaller, and more preferably has a thickness of 20 nm or larger and 900 nm or smaller. The light absorption layer 13 absorbs incident light through the transparent electroconductive layer 11 and the hole transport layer 12. The absorbed light excites electrons and produces electrons and holes inside the light absorption layer 13. The holes generated inside the light absorption layer 13 are transported through the hole transport layer 12 and the transparent electroconductive layer 11, to the lower electrode 16. The electrons generated inside the light absorption layer 13 are transported through the electron transport layer 14, to the upper electrode 15. Upon transport of the holes generated inside the light absorption layer 13 to the lower electrode 16, and upon transport of the electrons generated inside the light absorption layer 13 to the upper electrode 15, the photoelectric conversion element 1 obtains electromotive force.

The electron transport layer 14 is an n-type semiconductor layer capable of blocking the holes generated in the light absorption layer 13, and of transporting the electrons generated in the light absorption layer 13 to the upper electrode 15 with high efficiency. The electron transport layer 14 is formed on the light absorption layer 13 so as to cover it, while opposing one face thereof to the other face of the light absorption layer 13. The electron transport layer 14 is preferably formed of a material having high electron transport characteristic. The electron transport layer 14 is formed of, for example, metal oxide such as titanium oxide (TiO₂, etc.), tin oxide (SnO₂, etc.), zinc oxide (ZnO), or aluminum oxide (Al₂O₃); or C-based semiconductor such as fullerene (C₆₀) or phenyl-C₆₁-butyric acid methyl ester (PCBM). The electron transport layer 14 preferably has a thickness of 1 nm or larger and 200 nm or smaller, and more preferably has a thickness of 2 nm or larger and 60 nm or smaller. Among them, the electron transport layer 14, formed on the light absorption layer 13, is preferably formed of C₆₀ or PCBM which may be formed at low temperatures, and can establish well-matched band alignment. When using C₆₀ or PCBM, the electron transport layer 14 preferably has a thickness of 2 nm or larger and 40 nm or smaller. When using C₆₀ or PCBM, and if C₆₀ or PCBM is made thicker beyond 40 nm, the series resistance would increase and thus degrade the conversion efficiency. If it is made thinner below 2 nm, the conversion efficiency would degrade due to temporal change.

The upper electrode 15 is constituted of a first electroconductive layer 151, a second electroconductive layer 152, and a third electroconductive layer 153, stacked in this order when viewed from the electron transport layer 14.

The first electroconductive layer 151 is a layer structured to make ohmic contact with the electron transport layer 14, and to prevent diffusion of the halide ions towards the second electroconductive layer 152, and may, for example, be a Bi layer that contains bismuth (Bi). From the viewpoint of blocking diffusion of the halide ions, the first electroconductive layer 151 preferably has a thickness of 10 nm or larger and 70 nm or smaller, and more preferably has a thickness of 40 nm or larger and 70 nm or smaller.

The second electroconductive layer 152 is a layer structured to prevent diffusion of a part of the composition of the third electroconductive layer 153 towards the electron transport layer 14 or the light absorption layer 13, and may, for example, be a Ti layer that contains titanium (Ti) or a Cr layer that contains chromium (Cr). The second electroconductive layer 152 preferably has a thickness of 2 nm or larger and 60 nm or smaller, and more preferably has a thickness of 10 nm or larger and 20 nm or smaller.

The third electroconductive layer 153 is arranged on the outermost face of the photoelectric conversion element 1, which is less reactive with oxygen or the halide ions than the second electroconductive layer 152, and may, for example, be an Au layer that contains gold (Au). From the viewpoint of efficiently collecting electric current, the third electroconductive layer preferably has a thickness of 10 nm or larger and 20 nm or smaller. If the third electroconductive layer 153 has a large work function, it tends to be less oxidizable and less reactive with the halide ion, therefore it is preferred to contain a substance with a work function of 5.0 eV or larger. The substance with a work function of 5.0 eV or larger is exemplified by platinum (Pt) or carbon (C), rather than aforementioned Au. The third electroconductive layer 153 may alternatively employ a transparent conductive oxide (TCO) such as indium tin oxide (ITO) or aluminum-doped zinc oxide (AZO), as the material less oxidizable in the air and less reactive with the halide ion.

With the upper electrode 15 containing the first electroconductive layer 151, the second electroconductive layer 152 and the third electroconductive layer 153, the photoelectric conversion element 1 can prevent mutual diffusion of the metals and the halogen in the light absorption layer and can therefore provide a solar cell that excels in the conversion efficiency and long-term stability.

In addition, C₆₀, having been widely used for the electron transport layer in the prior inverted structure, does not so excel in electron transport characteristic, therefore needs to be thinned. Moreover, the metals with a small work function, and capable of making ohmic contact with the electron transport layer is likely to diffuse and to react with the halogen that constituting the light absorption layer, thus degrading the long-term stability. Moreover, this sort of metal is likely to be oxidized, so that the electrode will be oxidized on the surface, will elevate the series resistance, and will degrade the conversion efficiency. Au, although being a stable metal less likely to be oxidized, has a large work function, and makes Schottky contact with the electron transport layer, thus degrading the characteristic. Au is also likely to diffuse into the electron transport layer or the light absorption layer, which would cause leakage current. Therefore, there has been a proposal of an electrode having Ti interposed between Au and the electron transport layer (Non Patent Literature 2, for example). Although being capable of suppressing diffusion of Au into the electron transport layer or into the light absorption layer, however, Ti can react with the halide ion, which diffused from the light absorption layer and to raise the resistivity. Therefore, Ti cannot be thickened and will degrade the characteristic due to insufficient performance. Another proposal has been made on an electrode with use of Bi as the electrode, or as an electrode insert between Ag and the electron transport layer (Non Patent Literature 1, for example). Although Bi is less reactive with the halide ion than Ti, Bi can react with the halide ion with over time, thus degrading the electron collecting ability due to insufficient performance.

Therefore, the first embodiment 1 employs the Bi layer that is less likely to react with the halide ion, in a part of the electrode closer to the electron transport layer so as to make ohmic contact with the electron transport layer, and provides thereon the Au electrode which is less oxidizable and less reactive with the halide ion. Here, Au is likely to diffuse, which cannot be prevented the diffuse of Au efficiently by the Bi layer. Therefore, by further interposing the Ti layer or the Cr layer, between the Bi layer and the Au layer, for preventing diffusion of Au so as to make the electrode (upper electrode 15 used in the first embodiment) having a structure of Bi layer/Ti layer, or Cr layer/Au layer. It becomes possible to greatly improve power generation characteristic, as well as the stability, of the solar cell that contains the photoelectric conversion element 1.

As described above, with the electrode manufactured by stacking with the Bi layer/Ti layer or the Cr layer/Au layer, the photoelectric conversion element 1 can improve not only prevention of diffusion, but also contact with the light absorption layer. That is, the photoelectric conversion elements 1 excels in the conversion efficiency, and may be stably used for a long term.

The lower electrode 16 is formed of a material that makes ohmic contact, at a joint face with the transparent electroconductive layer 11 arranged below. For example, the lower electrode 16 may be formed on the transparent electroconductive layer 11, similarly to the upper electrode 15, and may be structured to have the first electroconductive layer, the second electroconductive layer, and the third electroconductive layer stacked in this order as viewed from the transparent electroconductive layer 11. More specifically, the lower electrode 16 is structured by stacking a Bi layer that contains bismuth (Bi) as the first electroconductive layer, a Ti layer that contains titanium (Ti) or a Cr layer that contain chromium (Cr) as the second electroconductive layer, and an Au layer that contains gold (Au) as the third electroconductive layer, in this order as viewed from the transparent electroconductive layer 11. This structure is advantageous since it may be manufactured by the same process concurrently with the upper electrode 15. The lower electrode 16 may alternatively be formed of a metal having a relatively small work function such as Ag, Al, or Zn, or may be formed of a carbon-based electrode such as graphite. The lower electrode 16 may be formed of a single metal layer made of any of Ti, Ag, Al, Zn or the like, or may have less oxidizable Au, Pt or the like further formed thereon, so as to prevent oxidation by oxygen in the air. The lower electrode 16 may alternatively be formed of a transparent electroconductive film having high conductivity, such as ITO. The lower electrode 16 preferably has a thickness of 2 nm or larger and 200 nm or smaller. With the thickness smaller than 2 nm, the lower electrode 16 will have an increased resistivity in the direction the lower electrode 16 extends, thereby it would cause reducing the hole collection efficiency, and degrading the conversion efficiency of the photoelectric conversion element 1. With the thickness of the lower electrode 16 thicker than 200 nm will have an increased the resistivity in the direction of the thickness, thereby degrading the conversion efficiency of the photoelectric conversion element 1, and it will need a larger amount of material for forming itself, whereby the manufacturing cost tends to increase.

The photoelectric conversion element 1 may be manufactured, for example, by the method below. The transparent electroconductive layer 11 is formed on the transparent substrate 10, typically by a film forming method such as vacuum evaporation, sputtering, CVD or plating. The transparent substrate 10, having the transparent electroconductive layer 11 formed thereon, is preferably cleaned in a cleaning process such as UV ozone cleaning. Next, the hole transport layer 12 is formed on the surface of the transparent electroconductive layer 11 having been formed on the transparent substrate 10, by a film forming method, typically, such as vacuum evaporation or sputtering. Next, the light absorption layer 13 is formed on the surface of the hole transport layer 12 having been formed on the transparent electroconductive layer 11, by a film forming method such as spin coating or inkjet method. Next, the electron transport layer 14 is formed on the surface of the light absorption layer 13 having been formed on the hole transport layer 12, by a film forming method such as vacuum evaporation or spin coating. Next, the upper electrode 15 is formed on the surface of the electron transport layer 14 having been formed on the light absorption layer 13, by a film forming method such as vacuum evaporation, sputtering or plating. In the vacuum evaporation, it is preferred to continuously form the Bi layer, the Ti layer or the Cr layer, and the Au layer, without opening the vacuum chamber. This successfully suppresses the Bi layer, or the Ti layer or the Cr layer from being oxidized. The lower electrode 16 is formed on the surface of the transparent electroconductive layer 11 having been formed on the transparent substrate 10, by a film forming method such as vacuum evaporation, sputtering or plating. The lower electrode 16 may be manufactured concurrently with the upper electrode 15.

### <Second Embodiment>

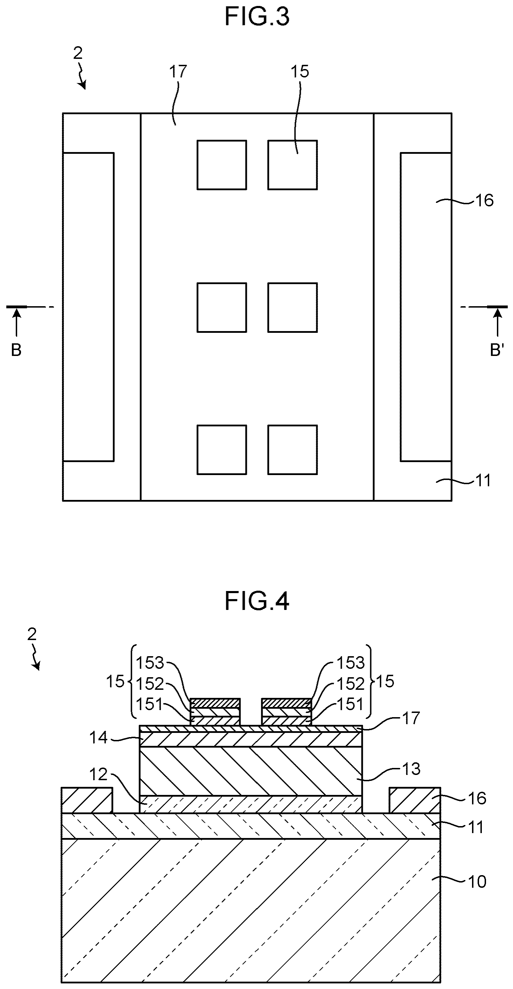

FIG. 3 is a plan view of a photoelectric conversion element according to a second embodiment, and FIG. 4 is a cross-sectional view taken along line B-B' in FIG. 3. A photoelectric conversion element 2 is different from the photoelectric conversion element 1, in that a contact layer 17 is further interposed between the electron transport layer 14 and the electrode (upper electrode 15). Structures and functions of the constituents of the photoelectric conversion element 2, other than the contact layer 17, are same as the structures and functions of the constituents of the photoelectric conversion element 1 denoted by the same reference numerals, and will not therefore be detailed herein. Also, the photoelectric conversion element 2 excels in the conversion efficiency, and may be stably used for a long term, similarly to the photoelectric conversion element 1.

With the contact layer 17 formed therein, the photoelectric conversion element 2 can further suppress the conversion efficiency from degrading due to changes over time. Also, the electrical contact is improved to establish ohmic contact between the electron transport layer 14 and the upper electrode 15. Bathocuproine (BCP) is a suitable material used for forming the contact layer 17. The contact layer 17 preferably has a thickness of 0.2 nm or larger and 5 nm or smaller.

The photoelectric conversion element 2 can be manufactured by, for example, the same manufacturing method as the photoelectric conversion element 1. A difference from the photoelectric conversion element 1 is that the contact layer 17 is formed on the surface of the electron transport layer 14 having been formed on the light absorption layer 13, by a film forming method such as spin coating or vacuum evaporation. The upper electrode 15 is formed on the surface of the contact layer 17 having been formed on the electron transport layer 14, in the same manner as for the photoelectric conversion element 1.

### <Modified Example>

The photoelectric conversion elements of the first and second embodiments may have a buffer layer formed between the transparent electroconductive layer 11 and the hole transport layer 12, as long as the layer does not shade the light, and does not interfere the hole transport. The buffer layer is formed of, for example, [2-(3,6-dimethoxy-9H-carbazol-9-yl)ethyl]phosphonic acid (MeO-2PACz).

The photoelectric conversion elements of the first and second embodiments may alternatively have the third electroconductive layer 153, the second electroconductive layer 152, the first electroconductive layer 151, the electron transport layer 14, the light absorption layer 13, the hole transport layer 12, and the transparent electroconductive layer 11, formed in this order on the transparent substrate 10, thereby being structured to allow the light incident on the transparent electroconductive layer 11 on the outermost side. This structure may alternatively employ a non-transparent substrate, in place of the transparent substrate 10.

### <Third Embodiment>

A solar cell of a third embodiment includes the aforementioned photoelectric conversion element. The solar cell excels in the conversion efficiency, and may be stably used for a long term. The solar cell is suitably used for portable devices. The portable devices are exemplified by wristwatch, pocket watch, gyro sensor, atmospheric pressure sensor, hearing aid, and handheld GPS; information devices such as digital camera, video camera, portable music player, IC recorder, portable video player, pocket computer, calculator, portable game machine, laptop computer, PDA, smartphone, portable printer, portable scanner, portable modem, and electronic dictionary; and communication devices such as mobile phone, satellite phone, pager, portable radio, portable television, one-segment, IC card with built-in processor, and RFID tag. The solar cell of the third embodiment and the portable devices having the same can be manufactured by any of known methods, with use of the aforementioned photoelectric conversion element.

Summarizing the above, the present inventions relate to the following.
[1] A photoelectric conversion element having a transparent electroconductive layer, a hole transport layer, a light absorption layer, an electron transport layer, and an electrode stacked in this order; the light absorption layer containing a material that contains a halide ion, the electrode having a first electroconductive layer, a second electroconductive layer, and a third electroconductive layer stacked in this order when viewed from the electron transport layer; the first electroconductive layer being structured to make ohmic contact with the electron transport layer, and to prevent the diffusion of the halide ion towards the second electroconductive layer; the second electroconductive layer being structured to prevent the diffusion of the third electroconductive layer towards the electron transport layer or the light absorption layer; and the third electroconductive layer being less reactive with oxygen or the halide ion, than the second electroconductive layer is.
[2] The photoelectric conversion element according to claim 1, wherein the third electroconductive layer has a work function of 5.0 eV or larger.
[3] The photoelectric conversion element according to claim 1, wherein the first electroconductive layer contains Bi.
[4] The photoelectric conversion element according to claim 1, wherein the second electroconductive layer contains Ti or Cr.
[5] The photoelectric conversion element according to claim 1, wherein the third electroconductive layer contains Au, Pt, or C.
[6] A photoelectric conversion element having a transparent electroconductive layer, a hole transport layer, a light absorption layer, an electron transport layer, and an electrode stacked in this order; the light absorption layer containing a material that contains a halide ion, and the electrode having a Bi layer, a Ti layer or a Cr layer, and an Au layer stacked in this order when viewed from the electron transport layer.
[7] The photoelectric conversion element according to [6], wherein the material contained in the light absorption layer further contains silver ion and bismuth ion.
   These photoelectric conversion elements excel in conversion efficiency and may be stably used for a long term.
[8] The photoelectric conversion element according to claim [6] or [7], wherein the Bi layer has a thickness of 10 nm or larger and 70 nm or smaller. With the Bi layer fallen in the aforementioned range, the photoelectric conversion element can further suppress the halide ion from diffusing, and can improve the conversion efficiency.
[9] The photoelectric conversion element according to [6] or [7], wherein the Ti layer or the Cr layer has a thickness of 2 nm or larger and 60 nm or smaller. With the Ti layer or the Cr layer fallen in the aforementioned range, the photoelectric conversion element can further suppress Au from diffusing, and can improve the conversion efficiency.
[10] The photoelectric conversion element according to [6] or [7], wherein the Au layer has a thickness of 10 nm or larger and 20 nm or smaller. With the Au layer fallen in the aforementioned range, the photoelectric conversion element can collect electric current efficiently.
[11] The photoelectric conversion element according to [6] or [7], wherein the electron transport layer contains fullerene or phenyl-C₆₁-butyric acid methyl ester.
[12] The photoelectric conversion element according to [1] or [6], further comprising a contact layer interposed between the electron transport layer and the electrode, and the contact layer contains bathocuproine. With the contact layer interposed therein, the photoelectric conversion element can further suppress the conversion efficiency from degrading due changes over time.
[13] A solar cell having the photoelectric conversion element according to [1] or [6]. The solar cell excels in the conversion efficiency and may be stably used for a long term.

Hereinafter, the present invention will be described more specifically with reference to Examples, to which the present invention is by no means limited.

### [Examples]

### (Comparative Example 1)

Comparative Example 1 relates to a photoelectric conversion element, which is different from the photoelectric conversion element of the first embodiment in terms of the upper electrode 15. That is, the upper electrode and the lower electrode in Comparative Example 1 were formed of a Ti layer/Au layer, with the thickness of the Ti layer adjusted to 2 nm, and with the thickness of the Au layer adjusted to 70 nm.

First, a 25 mm × 25 mm planar ITO-glass substrate, composed of the transparent substrate 10 and the transparent electroconductive layer 11 formed thereon, was prepared. The thus prepared ITO-glass substrate was subjected to UV ozone cleaning. Here, a glass substrate that corresponds to the transparent substrate 10 was 1 mm thick, and an ITO film that corresponds to the transparent electroconductive layer 11 was 1 µm thick.

Next, a NiO:Zn layer that corresponds to the hole transport layer 12 was formed on a surface of the ITO film deposited on the ITO-glass substrate by vacuum evaporation with use of EX-200 from ULVAC, Inc. with heating by an EB gun. A material used for forming the hole transport layer 12 was prepared by mixing NiO powder and ZnO powder in a mortar while adjusting the Ni:Zn ratio to 90:10, and the mixture was press-molded and fired, to manufacture a tablet. The ITO-glass substrate, having the transparent electroconductive layer 11 formed thereon, was placed on a metal mask having a 25 mm × 15 mm opening, the NiO:Zn tablet was packed in a water-cooled hearth, and the inside of a vacuum chamber was evacuated down to 4 × 10⁻⁵ Torr or below. Next, the NiO:Zn sample was degassed, then the NiO:Zn sample was heated by the EB gun, and then a shutter was opened. Evaporated Particles from the NiO:Zn sample were to deposited on the surface of the transparent electroconductive layer 11.

Next, an AgBi_{2.25}I_{7.75} film that corresponds to the light absorption layer 13 was formed on a face of the hole transport layer 12 by spin coating. A solution that contains a rudorffite material precursor was prepared by placing AgI and BiI₃ in a container, and then pouring DMSO into the container having AgI and BiI₃ placed therein for dissolution. The AgI and BiI₃ placed in the container were prepared, so as to adjust the Ag:Bi:I ratio in the solution that contains the rudorffite material precursor to 1:2.25:7.75. The number of rotations in the spin coating was 4000 rpm, and the time over which the solution that contains the rudorffite material precursor was coated was 30 seconds. The ITO-glass substrate coated with the solution containing the rudorffite material precursor was precured at 70°C for 4 minutes, and then fired at 90°C for 1 hour, thereby forming a AgBi_{2.25}I_{7.75} film that corresponds to the light absorption layer 13 containing the rudorffite material. The film thickness of the formed AgBi_{2.25}I_{7.75} was 700 nm.

Next, a C₆₀ layer that corresponds to the electron transport layer 14 was formed on a surface of the light absorption layer 13, by vacuum evaporation with use of EX-200 from ULVAC, Inc. with heating by the EB gun. A material used for forming the electron transport layer 14 is C₆₀ powder. The ITO-glass substrate, having the light absorption layer 13 formed thereon, was placed on a metal mask having a 25 mm × 15 mm opening, the C₆₀ powder was packed in a water-cooled hearth, and the inside of a vacuum chamber was evacuated down to 4 × 10⁻⁵ Torr or below. Next, the C₆₀ powder was degassed, then the C₆₀ powder was heated by the EB gun, and the shutter was opened. Evaporated particles from the C₆₀ powder were deposited on the surface of the light absorption layer 13. The thickness of the formed C₆₀ layer was 2 nm.

Next, the region where the electron transport layer 14 was formed was demarcated by a metal mask, and parts of the hole transport layer 12, the light absorption layer 13, and the electron transport layer 14 exposed from the mask were removed with DMF.

Next, the Ti layer/Au layer that corresponds to each of the upper electrode 15 and the lower electrode 16 was formed on the surface of the ITO film and the C₆₀ layer by vacuum evaporation with use of EX-200 from ULVAC, Inc. under heating with the EB gun, whereby the photoelectric conversion element in Comparative Example 1 was completed. Now, the ITO-glass substrate was placed on a metal mask having formed therein two 3.25 mm × 20 mm openings through which the hole collection electrodes will be formed, and six 3.2 mm × 3.2 mm openings through which the electron collection electrodes will be formed, thereby demarcating deposition areas of the Ti layer/Au layer to desired areas.

Ti as an evaporation source, with a diameter of 1 mm or larger and 2 mm or smaller, was packed in a water-cooled hearth, followed by evacuation down to 4 × 10⁻⁵ Torr or below, degassing of the material, heating with the EB gun, and opening of the shutter, so as to cause deposition of the Ti layer to as thick as 2 nm. After thorough cooling of the water-cooled hearth packed with Ti, the target was switched with use of a rotation mechanism to the water-cooled hearth packed with Au having a diameter of 1 mm or larger and 2 mm or smaller. The chamber was then confirmed to be evacuated down to 4 × 10⁻⁵ Torr or below. Next, the material was degassed, heated with the EB gun, and then the shutter was opened, so as to cause deposition of the Au layer to as thick as 70 nm.

### (Comparative Example 2)

In Comparative Example 2, a photoelectric conversion element was obtained in the same manner as in Comparative Example 1, except that the thickness of the Ti layer/Au layer that corresponds to each of the upper electrode and the lower electrode was changed. That is, each of the upper electrode and the lower electrode in Comparative Example 2 was formed of the Ti layer/Au layer, with the thickness of the Ti layer adjusted to 20 nm, and with the thickness of the Au layer adjusted to 52 nm.

More specifically, each of the Ti layer/Au layer that corresponds to the upper electrode 15 and the lower electrode 16 was formed on the surface of the ITO film and the C₆₀ layer, by vacuum evaporation with use of EX-200 from ULVAC, Inc. under heating with the EB gun, whereby the photoelectric conversion element in Comparative Example 2 was completed. Now, the ITO-glass substrate was placed on a metal mask having formed therein two 3.25 mm × 20 mm openings through which the hole collection electrodes will be formed, and six 3.2 mm × 3.2 mm openings through which the electron collection electrodes will be formed, thereby demarcating deposition areas of the Ti layer/Au layer to desired areas.

Ti as an evaporation source, with a diameter of 1 mm or larger and 2 mm or smaller, was packed in a water-cooled hearth, followed by evacuation down to 4 × 10⁻⁵ Torr or below, degassing of the material, heating with the EB gun, and opening of the shutter, so as to cause deposition of a Ti layer to as thick as 20 nm. After thorough cooling of the water-cooled hearth packed with Ti, the target was switched with use of a rotation mechanism to the water-cooled hearth packed with Au having a diameter of 1 mm or larger and 2 mm or smaller. The chamber was then confirmed to be evacuated down to 4 × 10⁻⁵ Torr or below. Next, the material was degassed, heated with the EB gun, and then the shutter was opened, so as to cause deposition of an Au layer to as thick as 52 nm.

### (Comparative Example 3)

In Comparative Example 3, a photoelectric conversion element was obtained in the same manner as in Comparative Example 2, except that the thickness of the Ti layer/Au layer that corresponds to each of the upper electrode and the lower electrode was changed. That is, each of the upper electrode and the lower electrode in Comparative Example 3 was formed of the Ti layer/Au layer, with the thickness of the Ti layer adjusted to 70 nm, and with the thickness of the Au layer adjusted to 2 nm.

### (Comparative Example 4)

In Comparative Example 4, a photoelectric conversion element was obtained in the same manner as in Comparative Example 1, except that the Ti layer/Au layer that corresponds to each of the upper electrode and the lower electrode was changed to a Bi layer. That is, the upper electrode and the lower electrode in Comparative Example 4 was formed of the Bi layer, with the thickness adjusted to 72 nm.

More specifically, the Bi layer that corresponds to each of the upper electrode 15 and the lower electrode 16 was formed on the surface of the ITO film and the C₆₀ layer, by vacuum evaporation with use of EX-200 from ULVAC, Inc. under heating with the EB gun, whereby the photoelectric conversion element in Comparative Example 4 was completed. Now, the ITO-glass substrate was placed on a metal mask having formed therein two 3.25 mm × 20 mm openings through which the hole collection electrodes will be formed, and six 3.2 mm × 3.2 mm openings through which the electron collection electrodes will be formed, thereby demarcating deposition areas of the Bi layer to desired areas.

Bi as an evaporation source, with a diameter of 1 mm or larger and 2 mm or smaller, was packed in a water-cooled hearth, followed by evacuation down to 4 × 10⁻⁵ Torr or below, degassing of the material, heating with the EB gun, and opening of the shutter, so as to cause deposition of the Bi layer to as thick as 72 nm.

### (Reference Example 1)

In Reference Example 1, a photoelectric conversion element was obtained in the same manner as in Comparative Example 1, except that the Ti layer/Au layer that corresponds to each of the upper electrode and the lower electrode was changed to a Cr layer/Au layer. That is, Reference Example 1 has the upper electrode and the lower electrode each formed of the Cr layer/Au layer, with the thickness of the Cr layer adjusted to 2 nm, and with the thickness of the Au layer adjusted to 70 nm.

More specifically, the Cr layer/Au layer that corresponds to each of the upper electrode 15 and the lower electrode 16 was formed on the surface of the ITO film and the C₆₀ layer by vacuum evaporation with use of EX-200 from ULVAC, Inc. under heating with the EB gun, whereby the photoelectric conversion element in Reference Example 1 was completed. Now, the ITO-glass substrate was placed on a metal mask having formed therein two 3.25 mm × 20 mm openings through which the hole collection electrodes will be formed, and six 3.2 mm × 3.2 mm openings through which the electron collection electrodes will be formed, thereby demarcating deposition areas of the Cr layer/Au layer to desired areas.

Cr as an evaporation source, with a diameter of 1 mm or larger and 2 mm or smaller, was packed in a water-cooled hearth, followed by evacuation down to 4 × 10⁻⁵ Torr or below, degassing of the material, heating with the EB gun, and opening of the shutter, so as to cause deposition of the Cr layer to as thick as 2 nm. After thorough cooling of the water-cooled hearth packed with Cr, the target was switched with use of the rotation mechanism to the water-cooled hearth packed with Au having a diameter of 1 mm or larger and 2 mm or smaller. The chamber was then confirmed to be evacuated down to 4 × 10⁻⁵ Torr or below. Next, the material was degassed, heated with the EB gun, and the shutter was then opened, so as to cause deposition of the Au layer to as thick as 70 nm.

### (Reference Example 2)

In Reference Example 2, a photoelectric conversion element was obtained in the same manner as in Comparative Example 1, except that the Ti layer/Au layer that corresponds to each of the upper electrode and the lower electrode was changed to a Bi layer/Au layer. That is, Reference Example 2 has the upper electrode and the lower electrode each formed of the Bi layer/Au layer, with the thickness of the Bi layer adjusted to 2 nm, and with the thickness of the Au layer adjusted to 70 nm.

More specifically, the Bi layer/Au layer that corresponds to each of the upper electrode 15 and the lower electrode 16 was formed on the surface of the ITO film and the C₆₀ layer by vacuum evaporation with use of EX-200 from ULVAC, Inc. under heating with the EB gun, thereby manufacturing the photoelectric conversion element in Reference Example 2. Now, the ITO-glass substrate was placed on a metal mask having formed therein two 3.25 mm × 20 mm openings through which the hole collection electrodes will be formed, and six 3.2 mm × 3.2 mm openings through which the electron collection electrodes will be formed, thereby demarcating deposition areas of the Bi layer/Au layer to desired areas.

Bi as an evaporation source, with a diameter of 1 mm or larger and 2 mm or smaller, was packed in a water-cooled hearth, followed by evacuation down to 4 × 10⁻⁵ Torr or below, degassing of the material, heating with the EB gun, and opening of the shutter, so as to cause deposition of the Bi layer to as thick as 2 nm. After thorough cooling of the water-cooled hearth packed with Bi, the target was switched with use of the rotation mechanism to the water-cooled hearth packed with Au having a diameter of 1 mm or larger and 2 mm or smaller. The chamber was then confirmed to be evacuated down to 4 × 10⁻⁵ Torr or below. Next, the material was degassed, heated with the EB gun, and the shutter was then opened, so as to cause deposition of the Au layer to as thick as 70 nm.

### (Reference Example 3)

In Reference Example 3, a photoelectric conversion element was obtained in the same manner as in Reference Example 2, except that the thickness of the Bi layer/Au layer that corresponds to each of the upper electrode and the lower electrode was changed. That is, Reference Example 3 has the upper electrode and the lower electrode each formed of the Bi layer/Au layer, with the thickness of the Bi layer adjusted to 10 nm, and with the thickness of the Au layer adjusted to 62 nm.

### (Reference Example 4)

In Reference Example 4, a photoelectric conversion element was obtained in the same manner as in Comparative Example 1, except that the Ti layer/Au layer that corresponds to each of the upper electrode and the lower electrode was changed to a Bi layer/Ti layer. That is, Reference Example 4 has the upper electrode and the lower electrode each formed of the Bi layer/Ti layer, with the thickness of the Bi layer adjusted to 70 nm, and with the thickness of the Ti layer adjusted to 30 nm.

More specifically, the Bi layer/Ti layer that corresponds to each of the upper electrode 15 and the lower electrode 16 was formed on the surface of the ITO film and the C₆₀ layer by vacuum evaporation with use of EX-200 from ULVAC, Inc. under heating with the EB gun, thereby manufacturing the photoelectric conversion element in Reference Example 4. Now, the ITO-glass substrate was placed on a metal mask having formed therein two 3.25 mm × 20 mm openings through which the hole collection electrodes will be formed, and six 3.2 mm × 3.2 mm openings through which the electron collection electrodes will be formed, thereby demarcating deposition areas of the Bi layer/Ti layer to desired areas.

Bi as an evaporation source, with a diameter of 1 mm or larger and 2 mm or smaller, was packed in a water-cooled hearth, followed by evacuation down to 4 × 10⁻⁵ Torr or below, degassing of the material, heating with the EB gun, and opening of the shutter, so as to cause deposition of the Bi layer to as thick as 70 nm. After thorough cooling of the water-cooled hearth packed with Bi, the target was switched with use of the rotation mechanism to the water-cooled hearth packed with Ti having a diameter of 1 mm or larger and 2 mm or smaller. The chamber was then confirmed to be evacuated down to 4 × 10⁻⁵ Torr or below. Next, the material was degassed, heated with the EB gun, and the shutter was then opened, so as to cause deposition of the Ti layer to as thick as 30 nm.

### (Example 1)

Example 1 relates to a photoelectric conversion element of the first embodiment. That is, the upper electrode 15 in Example 1 was formed of the Bi layer/Ti layer/Au layer, while adjusting the Bi layer 10 nm thick, the Ti layer 2 nm thick, and the Au layer 60 nm thick.

First, a 25 mm × 25 mm planar ITO-glass substrate, composed of the transparent substrate 10 and the transparent electroconductive layer 11 formed thereon, was prepared. The thus prepared ITO-glass substrate was subjected to UV ozone cleaning. Here, a glass substrate that corresponds to the transparent substrate 10 was 1 mm thick, and an ITO film that corresponds to the transparent electroconductive layer 11 was 1 µm thick.

Next, a NiO:Xn layer that corresponds to the hole transport layer 12 was formed on a face of the ITO film having been formed on the ITO-glass substrate, by vacuum evaporation with use of EX-200 from ULVAC, Inc. under heating with an EB gun. A material used for forming the hole transport layer 12 was prepared by mixing NiO powder and ZnO powder in a mortar while adjusting the Ni:Zn ratio to 90:10, and the mixture was press-molded and fired, to manufacture a tablet. The ITO-glass substrate, having the transparent electroconductive layer 11 formed thereon, was placed on a metal mask having a 25 mm × 15 mm opening, the NiO:Zn tablet was packed in a water-cooled hearth, and the inside of a vacuum chamber was evacuated down to 4 × 10⁻⁵ Torr or below. Next, the NiO:Zn sample was degassed, the NiO:Zn sample was then heated by the EB gun, and a shutter was then opened. Evaporated particles from the NiO:Zn sample were allowed to deposit on the surface of the transparent electroconductive layer 11.

Next, an AgBi_{2.25}I_{7.75} film that corresponds to the light absorption layer 13 was formed on a face of the hole transport layer 12 by spin coating. A solution that contains a rudorffite material precursor was prepared by placing AgI and BiI₃ in a container, and then pouring DMSO into the container having AgI and BiI₃ placed therein for dissolution. The AgI and BiI₃ placed in the container were prepared, so as to adjust the Ag:Bi:I ratio in the solution that contains the rudorffite material precursor to 1:2.25:7.75. The number of rotations in the spin coating was 4000 rpm, and the time over which the solution that contains the rudorffite material precursor was coated was 30 seconds. The ITO-glass substrate coated with the solution containing the rudorffite material precursor was precured at 70°C for 4 minutes, and then fired at 90°C for 1 hour, thereby forming a AgBi_{2.25}I_{7.75} film that corresponds to the light absorption layer 13 containing the rudorffite material. The thickness of the formed AgBi_{2.25}I_{7.75} film was 700 nm.

Next, the C₆₀ layer that corresponds to the electron transport layer 14 was formed on a face of the light absorption layer 13, by vacuum evaporation with use of EX-200 from ULVAC, Inc. under heating with the EB gun. A material used for forming the electron transport layer 14 is C₆₀ powder. First, the ITO-glass substrate, having the light absorption layer 13 formed thereon, was placed on a metal mask having a 25 mm × 15 mm opening, the C₆₀ powder was packed in a water-cooled hearth, and the inside of the vacuum chamber was evacuated to 4 × 10⁻⁵ Torr or below. Next, the C₆₀ powder was degassed, then the C₆₀ powder was heated by the EB gun, and the shutter was opened. Evaporated particles from the C₆₀ sample were allowed to deposit on the surface of the light absorption layer 13. The thickness of formed C₆₀ layer was 2 nm.

Next, the region where the electron transport layer 14 was formed was demarcated by a metal mask, and parts of the hole transport layer 12, the light absorption layer 13, and the electron transport layer 14 exposed from the mask were removed with DMF.

More specifically, the Bi layer/Ti layer/Au layer that corresponds to each of the upper electrode 15 and the lower electrode 16 was formed on the surface of the ITO film and the C₆₀ layer by vacuum evaporation with use of EX-200 from ULVAC, Inc. under heating with the EB gun, whereby the photoelectric conversion element in Example 1 was completed. Now, the ITO-glass substrate was placed on a metal mask having formed therein two 3.25 mm × 20 mm openings through which the hole collection electrodes will be formed, and six 3.2 mm × 3.2 mm openings through which the electron collection electrodes will be formed, thereby demarcating deposition areas of the Bi layer/Ti layer/Au layer to desired areas.

Bi as an evaporation source, with a diameter of 1 mm or larger and 2 mm or smaller, was packed in a water-cooled hearth, followed by evacuation down to 4 × 10⁻⁵ Torr or below, degassing of the material, heating with the EB gun, and opening of the shutter, so as to cause deposition of the Bi layer to as thick as 10 nm. After thorough cooling of the water-cooled hearth packed with Bi, the target was switched with use of the rotation mechanism to the water-cooled hearth packed with Ti with a diameter of 1 mm or larger and 2 mm or smaller, followed by evacuation down to 4 × 10⁻⁵ Torr or below, degassing of the material, heating with the EB gun, and opening of the shutter, so as to cause deposition of the Ti layer to as thick as 2 nm. After thorough cooling of the water-cooled hearth packed with Ti, the target was switched with use of a rotation mechanism to the water-cooled hearth packed with Au having a diameter of 1 mm or larger and 2 mm or smaller. The chamber was then confirmed to be evacuated down to 4 × 10⁻⁵ Torr or below. Next, the material was degassed, heated with the EB gun, and then the shutter was opened, so as to cause deposition of the Au layer to as thick as 60 nm.

### (Examples 2 to 7)

In Examples 2 to 7, the photoelectric conversion element 1 was obtained in the same manner as in Example 1, except that the thickness of the Bi layer/Ti layer/Au layer that corresponds to each of the upper electrode 15 and the lower electrode 16 was changed. That is, the upper electrode 15 and the lower electrode 16 in Examples 2 to 7 were formed of the Bi layer/Ti layer/Au layer.

In Example 2, the electrodes were manufactured, while adjusting the Bi layer 10 nm thick, the Ti layer 10 nm thick, and the Au layer 52 nm thick.

In Example 3, the electrodes were manufactured, while adjusting the Bi layer 50 nm thick, the Ti layer 10 nm thick, and the Au layer 20 nm thick.

In Example 4, the electrodes were manufactured, while adjusting the Bi layer 50 nm thick, the Ti layer 20 nm thick, and the Au layer 20 nm thick.

In Example 5, the electrodes were manufactured, while adjusting the Bi layer 20 nm thick, the Ti layer 10 nm thick, and the Au layer 40 nm thick.

In Example 6, the electrodes were manufactured, while adjusting the Bi layer 40 nm thick, the Ti layer 10 nm thick, and the Au layer 20 nm thick.

In Example 7, the electrodes were manufactured, while adjusting the Bi layer 70 nm thick, the Ti layer 10 nm thick, and the Au layer 20 nm thick.

### (Examples 8 and 9)

In Examples 8 and 9, the photoelectric conversion element 1 was obtained in the same manner as in Examples 3 and 4, except that the Bi layer/Ti layer/Au layer that corresponds to each of the upper electrode 15 and the lower electrode 16 was changed to a Bi layer/Cr layer/Au layer. More specifically, the photoelectric conversion element 1 was obtained in the same manner as in Examples 3 and 4, except that the upper electrode 15 and the lower electrode 16 were formed with use of Cr having a diameter of 1 mm or larger and 2 mm or smaller as the evaporation source, in place of Ti having a diameter of 1 mm or larger and 2 mm or smaller. That is, the upper electrode 15 and the lower electrode 16 in Examples 8 and 9 were formed of the Bi layer/Cr layer/Au layer.

In Example 8, the electrodes were manufactured, while adjusting the Bi layer 50 nm thick, the Cr layer 10 nm thick, and the Au layer 20 nm thick.

In Example 9, the electrodes were manufactured, while adjusting the Bi layer 50 nm thick, the Cr layer 20 nm thick, and the Au layer 20 nm thick.

### (Example 10)

Example 10 relates to a photoelectric conversion element of the second embodiment. That is, the upper electrode 15 and the lower electrode 16 in Example 10 were formed of the Bi layer/Ti layer/Au layer, while adjusting the Bi layer 20 nm thick, the Ti layer 10 nm thick, and the Au layer 40 nm thick.

The process up to formation of the C₆₀ layer that corresponds to the electron transport layer 14 was conducted in the same manner as in Example 1. Next, a BCP layer that corresponds to the contact layer 17 was formed on a face of the electron transport layer 14, by vacuum evaporation with use of EX-200 from ULVAC, Inc. under heating with the EB gun. A material used for forming the contact layer 17 was BCP powder. The ITO-glass substrate, having the electron transport layer 14 formed thereon, was placed on a metal mask having a 25 mm × 15 mm opening, the BCP powder was packed in a water-cooled hearth, and the inside of a vacuum chamber was evacuated down to 4 × 10⁻⁵ Torr or below. Next, the BCP powder was degassed, then the BCP powder was heated by the EB gun, and then the shutter was opened. Evaporated particles from the BCP powder were allowed to deposit on the surface of the electron transport layer 14. The thickness of formed contact layer 17 was 0.2 nm.

Next, the region where the contact layer 17 was formed was demarcated by a metal mask, and parts of the hole transport layer 12, the light absorption layer 13, the electron transport layer 14, and the contact layer 17 exposed from the mask were removed with DMF.

Next, the upper electrode 15 and the lower electrode 16 were formed on the surface of the ITO film and the contact layer by vacuum evaporation with use of EX-200 from ULVAC, Inc. under heating with the EB gun, whereby the photoelectric conversion element in Example 10 was completed. Now, the ITO-glass substrate was placed on a metal mask having formed therein two 3.25 mm × 20 mm openings through which the hole collection electrodes will be formed, and six 3.2 mm × 3.2 mm openings through which the electron collection electrodes will be formed, thereby demarcating deposition areas of the Bi layer/Ti layer/Au layer to desired areas.

Bi as an evaporation source, with a diameter of 1 mm or larger and 2 mm or smaller, was packed in a water-cooled hearth, followed by evacuation down to 4 × 10⁻⁵ Torr or below, degassing of the material, heating with the EB gun, and opening of the shutter, so as to cause deposition of the Bi layer to as thick as 20 nm. After thorough cooling of the water-cooled hearth packed with Bi, the target was switched with use of the rotation mechanism to the water-cooled hearth packed with Ti with a diameter of 1 mm or larger and 2 mm or smaller, and switched to the water-cooled hearth packed with Ti with a diameter of 1 mm or larger and 2 mm or smaller, followed by evacuation down to 4 × 10⁻⁵ Torr or below, degassing of the material, heating with the EB gun, and opening of the shutter, so as to cause deposition of the Ti layer to as thick as 10 nm. After thorough cooling of the water-cooled hearth packed with Ti, the target was switched with use of a rotation mechanism to the water-cooled hearth packed with Au having a diameter of 1 mm or larger and 2 mm or smaller. The chamber was then confirmed to be evacuated down to 4 × 10⁻⁵ Torr or below. Next, the material was degassed, heated with the EB gun, and then the shutter was opened, so as to cause deposition of the Au layer to as thick as 40 nm.

### (Example 11)

In Example 11, a photoelectric conversion element was obtained in the same manner as in Example 9, except that the upper electrode and the lower electrode were formed of the Bi layer/Cr layer/Pt layer. More specifically, the Pt layer was formed with use of Pt having a diameter of 1 mm or larger and 2 mm or smaller, as an evaporation source. In Example 11, the electrodes were manufactured, while adjusting the Bi layer 50 nm thick, the Cr layer 20 nm thick, and the Pt layer 20 nm thick.

### (Example 12)

In Example 12, a photoelectric conversion element was obtained with use of the Bi layer/Cr layer/C layer for each of the upper electrode and the lower electrode, while adjusting the C layer 6 nm thick. The Bi layer/Cr layer was formed in the same manner as in Example 9. The C layer was formed by depositing carbon to as thick as 6 nm, on the Cr layer in an evacuated chamber, under arc discharge. In Example 12, the electrodes were manufactured, while adjusting the Bi layer 50 nm thick, the Cr layer 20 nm thick, and the C layer 6 nm thick.

### (Comparative Example 5)

Comparative Example 5 relates to a photoelectric conversion element, whose upper electrode 15 and the lower electrode 16 are different from those of the photoelectric conversion element of the second embodiment. That is, the upper electrode and the lower electrode in Comparative Example 5 are formed of the Bi layer, with the thickness adjusted to 70 nm. More specifically, the photoelectric conversion element was obtained in the same manner as in Example 10, except that the upper electrode and the lower electrode were formed with use of Bi having a diameter of 1 mm or larger and 2 mm or smaller as the evaporation source, in place of Ti having a diameter of 1 mm or larger and 2 mm or smaller, while adjusting the Bi layer 70 nm thick.

### <Evaluation Method>

### (Method of Measuring Current-Voltage Characteristic under Photo-Illumination)

The current-voltage characteristic under photo-illumination was measured by the method below. A light source used herein was BLD-100 from Bunkoukeiki Co., Ltd. Light emitted from the light source to be incident on the photoelectric conversion element was adjusted to have an illuminance of 200 lx. The light emitted from the light source was adjusted to illuminate a 2.5 mm × 2.5 mm area through a shading mask. The light source and the photoelectric conversion element were arranged so that the light is incident on the photoelectric conversion element, through the transparent substrate. The current-voltage characteristic was measured with use of PECK2400-N from Pexcel Technologies, Inc., while sequentially sweeping voltage applied to the photoelectric conversion element from a negative level to a positive level. The characteristic was further measured by sequentially sweeping the voltage applied to the photoelectric conversion element from a positive level back to a negative level. The conversion efficiency was derived from the measured results of current-voltage characteristic. In the drawings presented below, the measured results of current-voltage characteristic were obtained by the negative-to-positive sequential sweeping (results of forward measurement), unless otherwise specified. Table 1 summarizes the conversion efficiency derived from the measured results of current-voltage characteristic. The photoelectric conversion elements, after manufactured and before being subjected to the measurement of current-voltage characteristic, were stored at room temperature with a humidity of 50%.

### <Results of Evaluation>

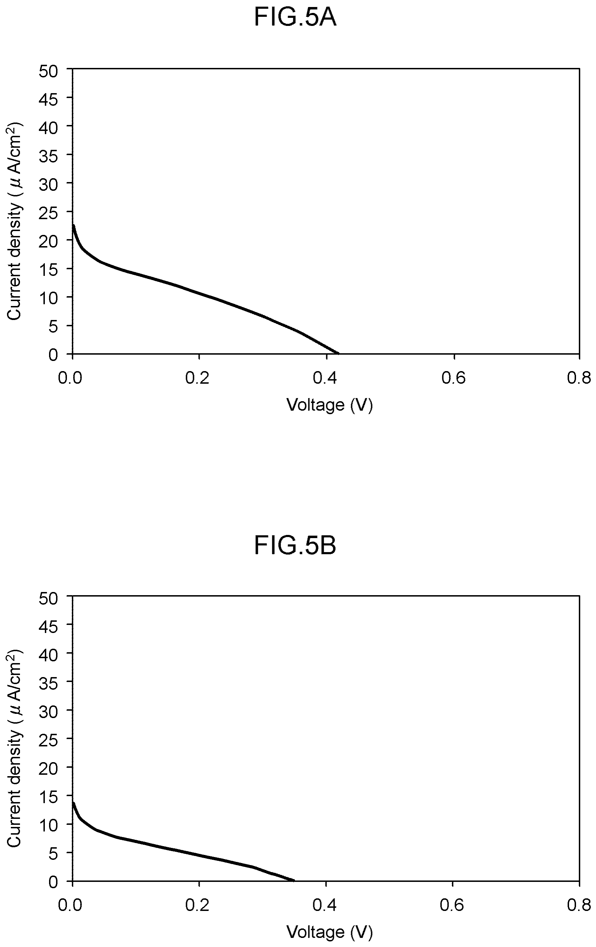

FIGS. 5A and 5B illustrate measured results of current-voltage characteristic of the photoelectric conversion element in Comparative Example 1. FIG. 5A illustrates the characteristic measured seven days after the manufacture of the photoelectric conversion element in Comparative Example 1, meanwhile FIG. 5B illustrates the characteristic measured after long term storage (15 days after) following the manufacture of the photoelectric conversion element of Comparative Example 1. With use of the Ti layer/Au layer, the upper electrode was suppressed from being denatured and was found to be largely improved in the initial characteristic as compared with the case having a single Au layer, however followed by degradation after the long-term storage.

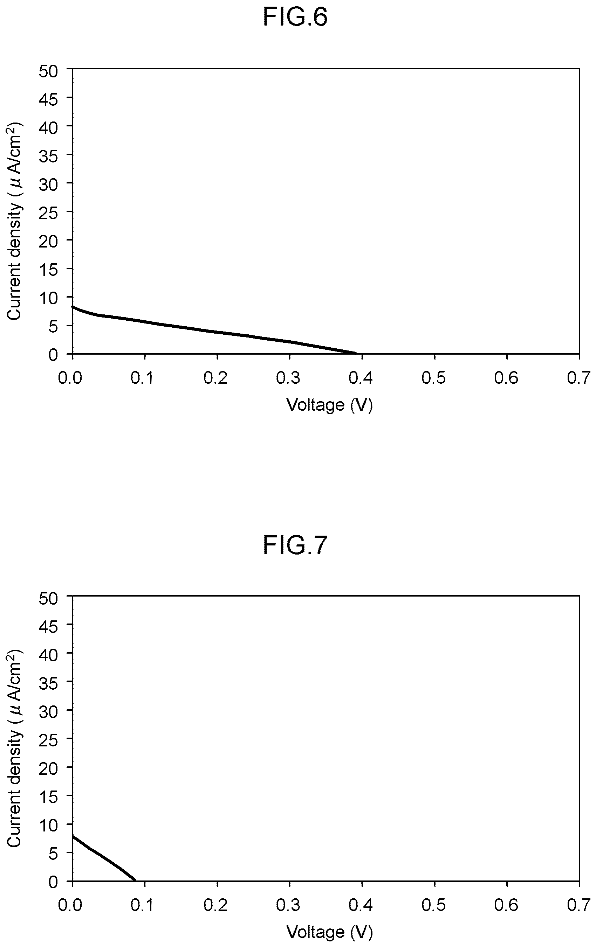

FIGS. 6 and 7 illustrate measured results of current-voltage characteristic of the photoelectric conversion elements in Comparative Examples 2 and 3, respectively. The characteristic was obtained 22 days after the manufacture of the photoelectric conversion elements of Comparative Examples 2 and 3. With use of the Ti layer/Au layer, the upper electrode increased the series resistance as the thickness of the Ti layer increased, and reduced the electric power generation.

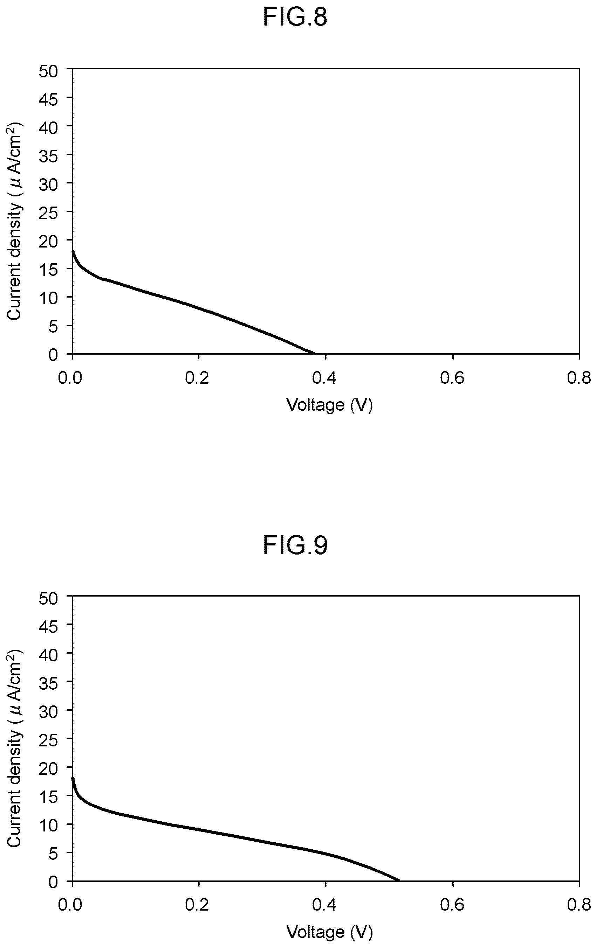

FIGS. 8 and 9 illustrate measured results of current-voltage characteristic of the photoelectric conversion elements in Reference Examples 2 and 3, respectively. The individual diagrams illustrate the characteristic obtained eight days after, and 14 days after the manufacture of the photoelectric conversion elements, respectively. With the upper electrode formed of the Bi layer/Au layer, Au was considered to have been diffused since the Au layer looked discolored. Diffusion of Au was observed similarly to the case of using the Au layer alone, from which degradation due to changes over a long term was concerned. On the other hand, increase of the thickness of the Bi layer can suppress the electric current from decreasing.

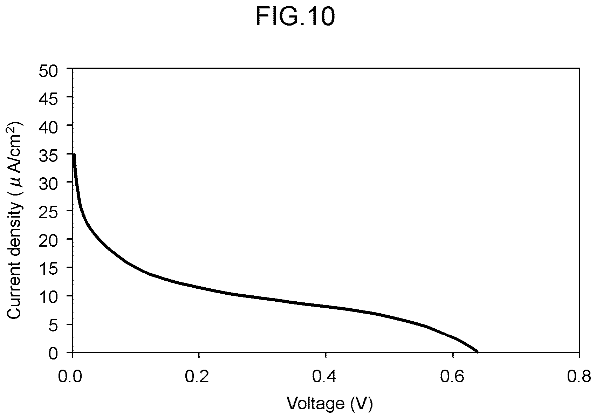

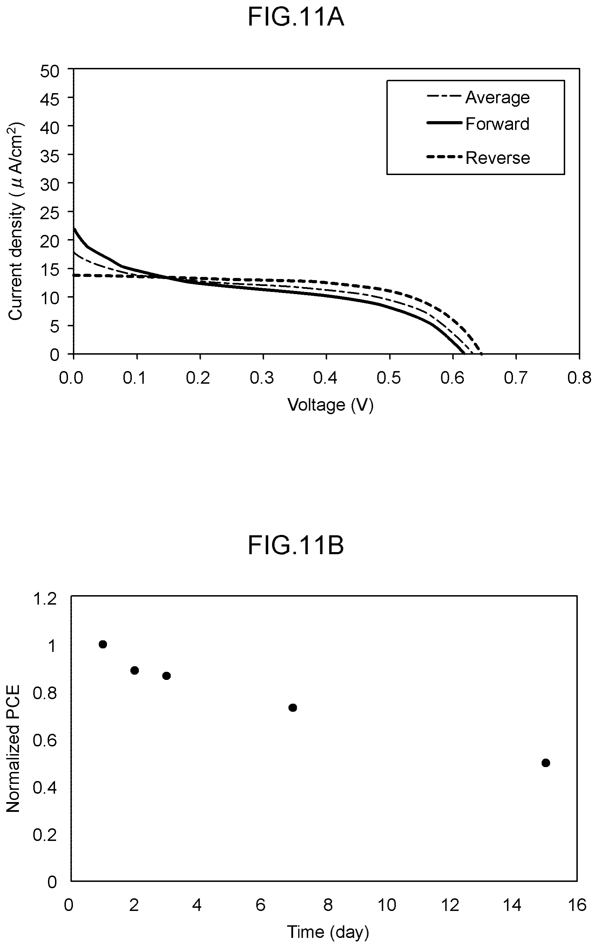

FIGS. 10 and 11A illustrate measured results of current-voltage characteristic of the photoelectric conversion elements 1 in Examples 1 and 2, respectively. The characteristic was obtained two days after the manufacture of the photoelectric conversion elements. FIG. 11A illustrates not only a result of measurement under the negative-to-positive sequential sweeping (result of forward measurement), but also a result of measurement under the positive-to-negative sequential sweeping (result of reverse measurement), and a result of averaging of the results of the forward measurement and the reverse measurement. Example 1 was found to improve the electrical contact as compared with the case of using a single Au layer, and to demonstrate high V_{OC}, however to demonstrate slight denaturation of the electrode, although the degree of which was smaller than in the electrode having the Bi layer/Au layer. Example 2 was found to improve the electrical contact as compared with the case of using a single Au layer, and to demonstrate high V_{OC}. Example 2, having an increased thickness of the Ti layer, was found to demonstrate minor increase in the series resistance, and a smaller degree of denaturation of the electrode. Examples 1 and 2 teach that insertion of the Bi layer between the electron transport layer and the Ti layer/Au layer can provide a photoelectric conversion element with less temporal degradation and high conversion efficiency. It was also found that the Ti layer may be thickened since the increased thickness of the Ti layer did not increase the series resistance, making the electrode less likely to denature, and more suppressive against Au diffusion.

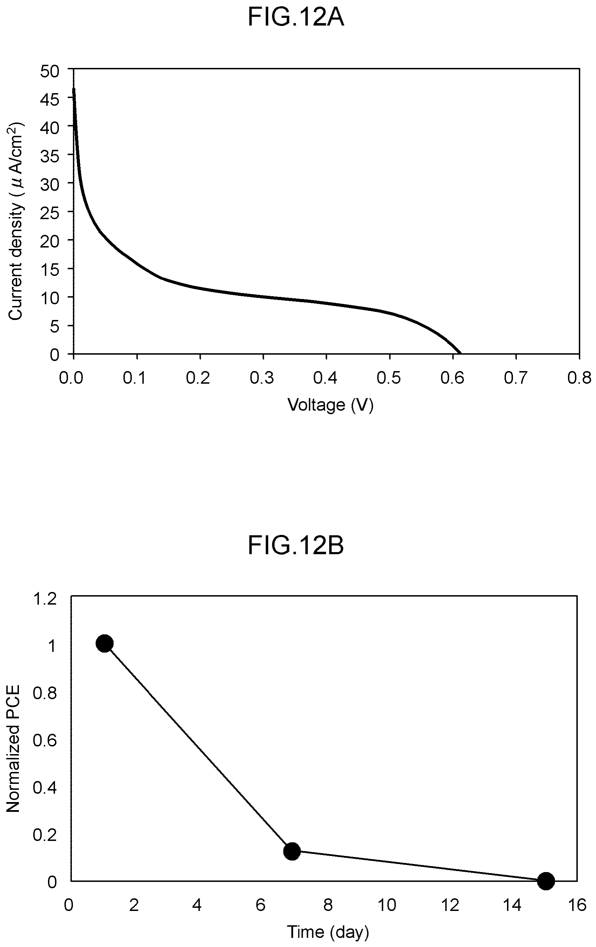

FIG. 11B is a diagram illustrating changes over time in conversion efficiency of the photoelectric conversion element 1 in Example 2. FIG. 11B is a diagram obtained by measuring current-voltage characteristic one day after, two days after, and three days after the manufacture of the photoelectric conversion element, then by measuring current-voltage characteristic after long term storage (seven days after and 15 days after), then by deriving the conversion efficiency from these measured results, and by plotting the conversion efficiency while normalized by the initial conversion efficiency (one day after). FIG. 12A illustrates a measured result of current-voltage characteristic of the photoelectric conversion element in Comparative Example 4. The characteristic was obtained one day after the manufacture of the photoelectric conversion element. FIG. 12B is a diagram illustrating changes over time in conversion efficiency of the photoelectric conversion element in Comparative Example 4. Also FIG. 12B is a diagram created in the same manner as FIG. 11B, except that the photoelectric conversion element in Comparative Example 4 was used. The photoelectric conversion element, having deposited therein the Bi layer/Ti layer/Au layer whose thickness is substantially equal to that of the Bi layer, was found to successfully suppress the power generation characteristic from degrading due to changes over time.

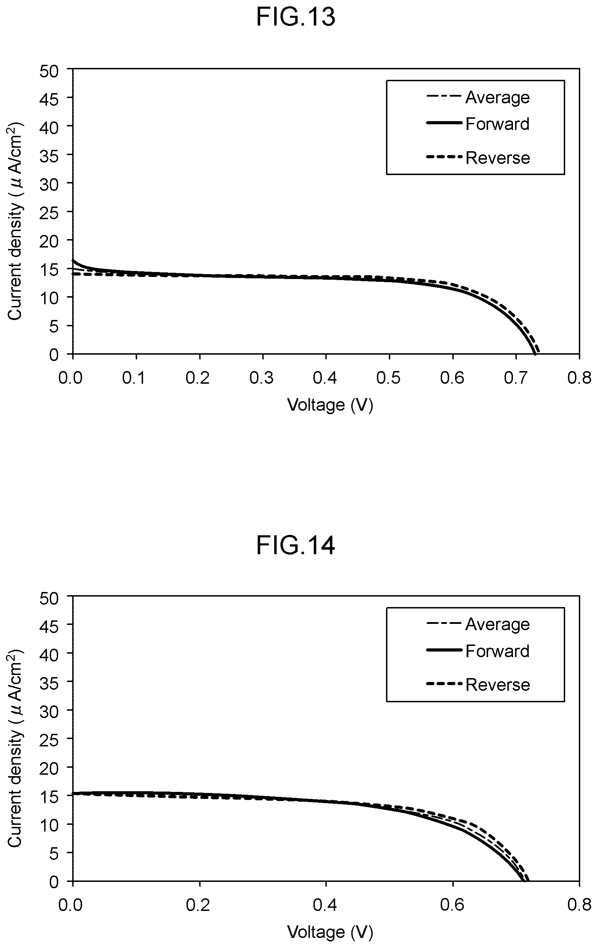

FIGS. 13 and 14 illustrate measured results of current-voltage characteristic of the photoelectric conversion elements 1 in Examples 3 and 4, respectively. The characteristic was obtained 13 days after the manufacture of the photoelectric conversion elements. Each diagram illustrates not only a result of measurement under the negative-to-positive sequential sweeping (result of forward measurement), but also a result of measurement under the positive-to-negative sequential sweeping (result of reverse measurement), and a result of averaging of the results of the forward measurement and the reverse measurement. The results teach that the Bi layer prevented diffusion of iodine, and that the conversion efficiency did not change largely despite the thickened Ti layer. In contrast, as illustrated in FIGS. 5A and 6, the Ti layer thickened in the absence of the Bi layer will cause iodization of Ti, thus degrading the conversion efficiency.

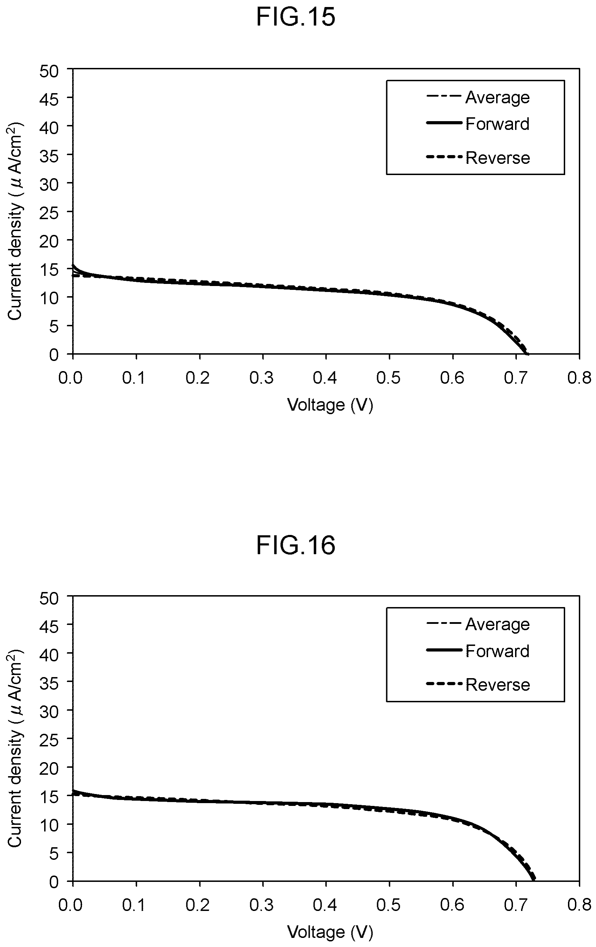

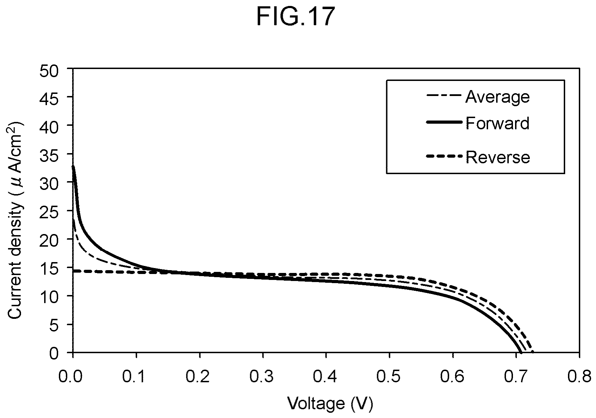

FIGS. 15 to 17 illustrate measured results of current-voltage characteristic of the photoelectric conversion elements 1 in Examples 5 to 7, respectively. The individual diagrams illustrate the characteristic obtained eight days after, eight days after, and 13 days after the manufacture of the photoelectric conversion elements, respectively. Each diagram illustrates not only a result of measurement under the negative-to-positive sequential sweeping (result of forward measurement), but also a result of measurement under the positive-to-negative sequential sweeping (result of reverse measurement), and a result of averaging of the results of the forward measurement and the reverse measurement. FIGS. 10, 13 and 15 to 17 teach that high conversion efficiency was obtained by thickening the Bi layer. A thickness of 40 nm or larger and 70 nm or smaller is considered to be preferred, which would be optimum at around 50 nm.

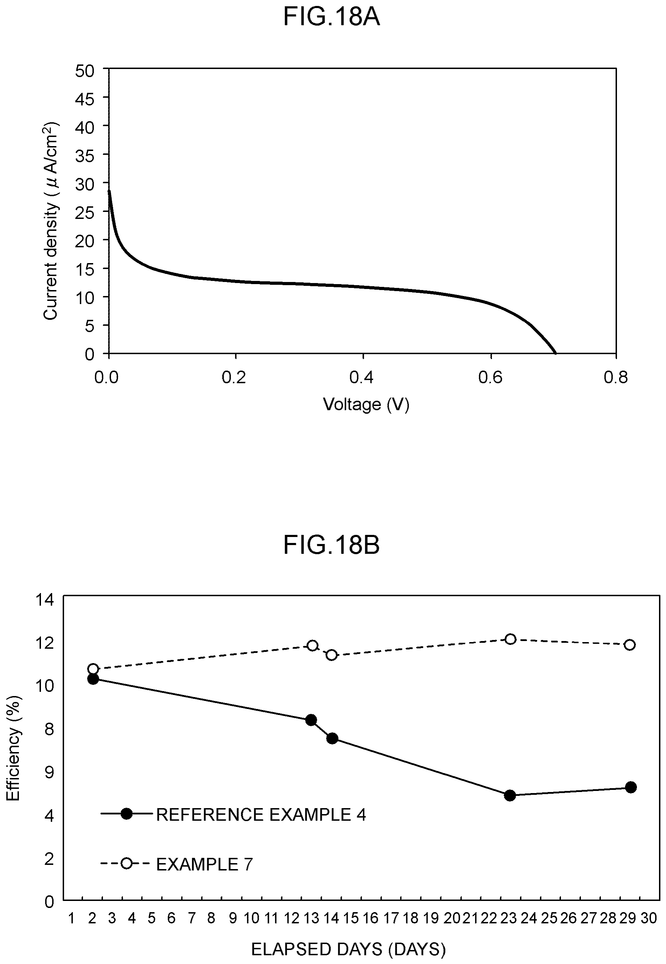

FIG. 18A is a diagram illustrating a measured result of current-voltage characteristic of the photoelectric conversion element in Reference Example 4. The characteristic was obtained two days after the manufacture of the photoelectric conversion elements. Meanwhile, FIG. 18B is a diagram illustrating changes over time in conversion efficiency of the photoelectric conversion element 1 in Example 7 and the photoelectric conversion element in Reference Example 4. FIG. 18B is a diagram plotting the conversion efficiency, obtained by measuring current-voltage characteristic two days after the manufacture of the photoelectric conversion element, then by measuring current-voltage characteristic after long term storage (13 days after, 14 days after, 23 days after, and 29 days after), then by deriving the conversion efficiency from these measured results. It is understood that the Bi layer/Ti layer/Au layer resulted in changes over time smaller than those resulted from the Bi layer/Ti layer.

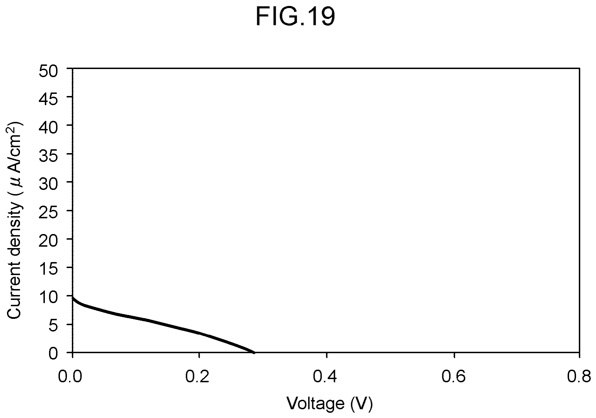

FIG. 19 is a diagram illustrating a measured result of current-voltage characteristic of the photoelectric conversion element in Reference Example 1. The characteristic was obtained seven days after the manufacture of the photoelectric conversion element. The Cr layer, having a large series resistance, was considered to lower the electric power generation even with a small thickness.

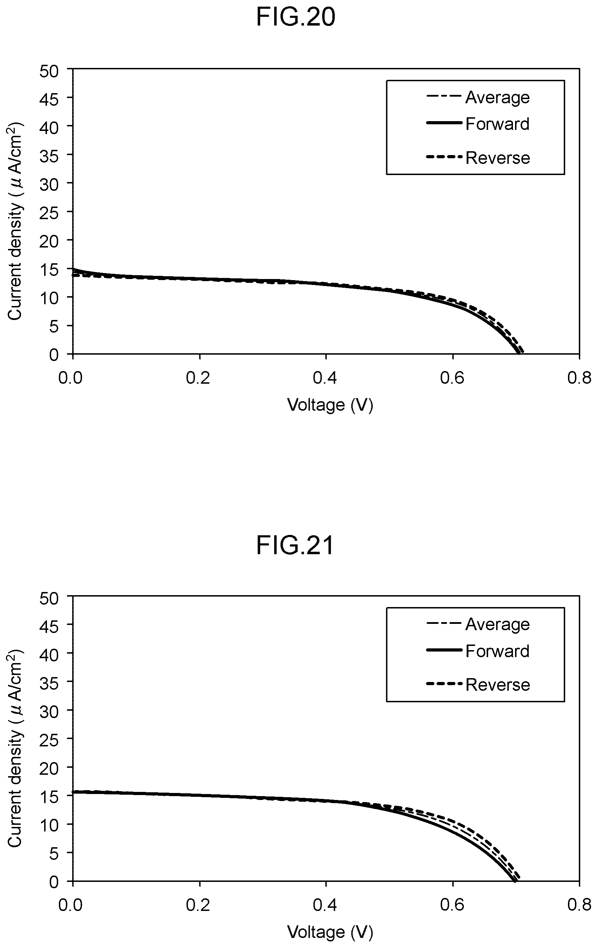

FIGS. 20 and 21 illustrate measured results of current-voltage characteristic of the photoelectric conversion elements 1 in Examples 8 and 9, respectively. The individual diagrams illustrate the characteristic obtained eight days after, and 15 days after the manufacture of the photoelectric conversion elements, respectively. Each diagram illustrates not only a result of measurement under the negative-to-positive sequential sweeping (result of forward measurement), but also a result of measurement under the positive-to-negative sequential sweeping (result of reverse measurement), and a result of averaging of the results of the forward measurement and the reverse measurement. FIGS. 13, 14, 20 and 21 teach that high conversion efficiency was successfully obtained by replacing the Ti layer in the Bi layer/Ti layer/Au layer with the Cr layer. It is therefore considered that Au diffusion was successfully blocked also with the Cr layer.

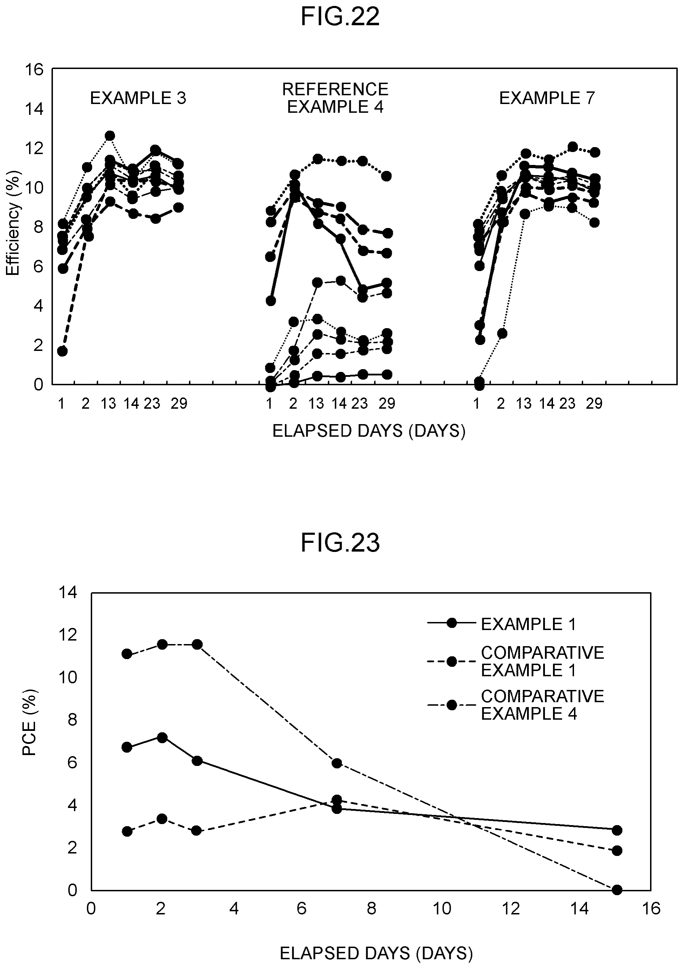

FIG. 22 is a diagram illustrating changes over time in conversion efficiency of nine photoelectric conversion elements 1 fabricated on the same transparent substrate 10, regarding the photoelectric conversion element 1 in Example 3, the photoelectric conversion element in Reference Example 4, and the photoelectric conversion element 1 in Example 7. The aforementioned nine photoelectric conversion elements 1 (cells A to I) were subjected to measurement of current-voltage characteristic, one day after and two days after the preparation of the photoelectric conversion element 1 in Example 3. The same aforementioned nine photoelectric conversion elements 1 (cells A to I) in Example 3 were subjected to the measurement, after long term storage following the manufacture (13 days after, 14 days after, 23 days after, and 29 days after). Also, the photoelectric conversion element in Reference Example 4 and the photoelectric conversion element 1 in Example 7 were subjected to the measurement of current-voltage characteristic, in the same manner. FIG. 22 illustrates the conversion efficiency obtained from these measurements. The conversion efficiency was considered to largely vary in the absence of the Au layer, since electron collection becomes insufficient while being affected by iodization due to iodine diffusion, and oxidation by oxygen in the air.

FIG. 23 is a diagram illustrating changes over time in conversion efficiency of the photoelectric conversion element 1 in Example 1, the photoelectric conversion element in Comparative Example 1, and the photoelectric conversion element in Comparative Example 4. FIG. 23 is a diagram plotting the conversion efficiency, obtained by measuring current-voltage characteristic one day after, two days after, and three days after the manufacture of the photoelectric conversion element, then by measuring current-voltage characteristic after long term storage (seven days after and 15 days after), then by deriving the conversion efficiency from these measured results. It is understood that the Bi layer/Ti layer/Au layer caused small changes over time.

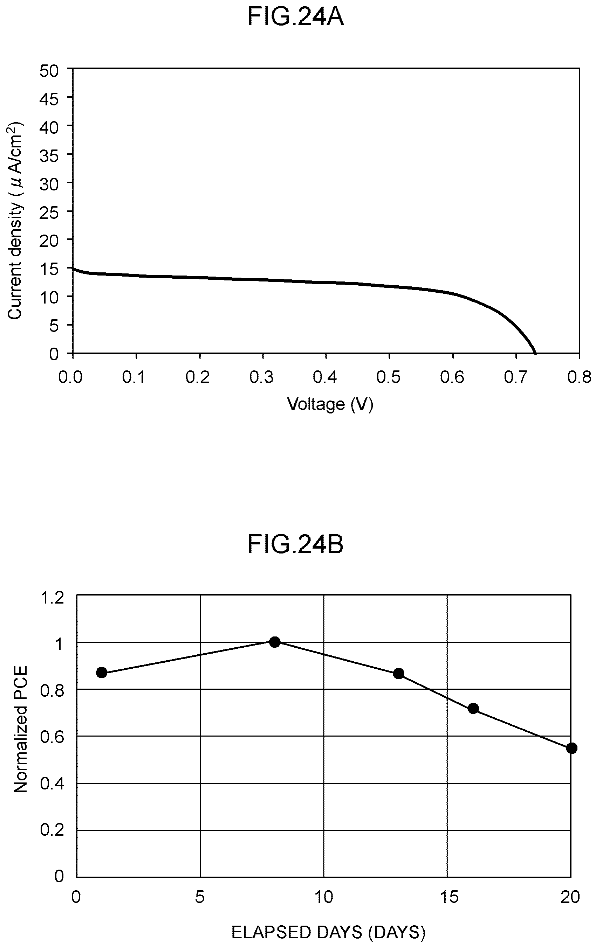

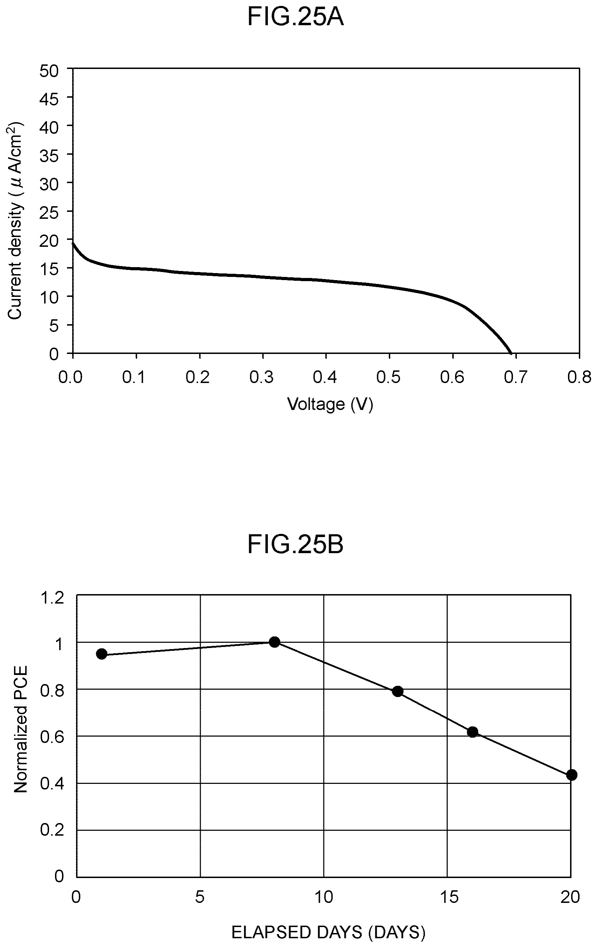

FIGS. 24A and 25A illustrate measured results of current-voltage characteristic of the photoelectric conversion elements 1 in Examples 10 and the photoelectric conversion element in Comparative Example 5, respectively. The individual diagrams illustrate the characteristic obtained eight days after, and one day after the manufacture of the photoelectric conversion elements, respectively. FIG. 24B is a diagram illustrating changes over time in conversion efficiency of the photoelectric conversion element 1 in Example 10. Note that FIG. 24B is a diagram obtained by measuring the initial (one day after) current-voltage characteristic after the manufacture of the photoelectric conversion element, then by measuring current-voltage characteristic after long term storage (eight days after, 13 days after, 16 days after, and 20 days after), then by deriving the conversion efficiency from these measured results, and by plotting the conversion efficiency while normalizing by the conversion efficiency eight days after. Also FIG. 25B is a diagram created in the same manner as FIG. 24B, except that the photoelectric conversion element in Comparative Example 5 was used. The results teach that provision of the contact layer can further suppress the conversion efficiency from degrading due to changes over time.

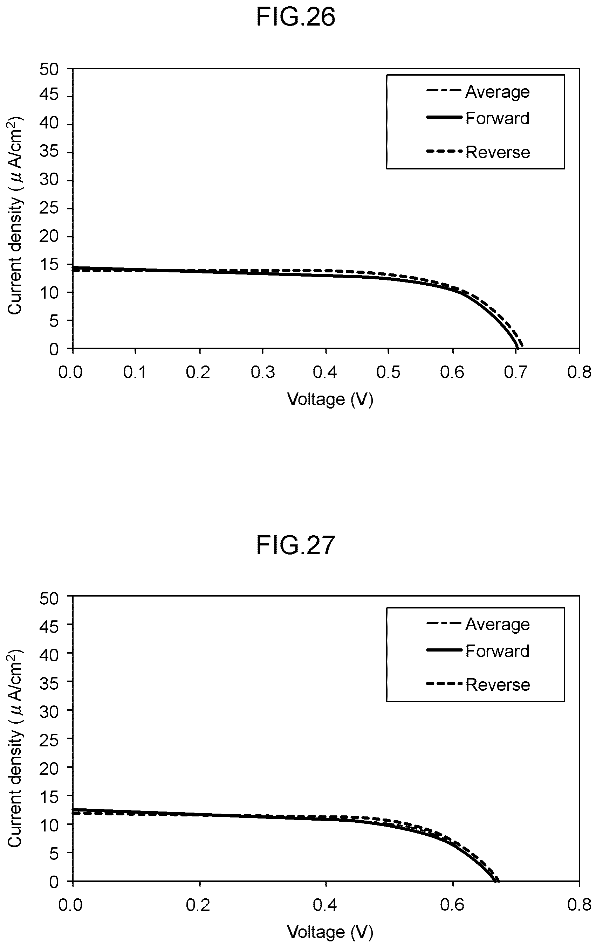

FIGS. 26, 27 and 28 illustrate measured results of current-voltage characteristic of the photoelectric conversion elements in Examples 9, 11 and 12, respectively. The characteristic was obtained 40 days after the manufacture of the photoelectric conversion element. Each diagram illustrates not only a result of measurement under the negative-to-positive sequential sweeping (result of forward measurement), but also a result of measurement under the positive-to-negative sequential sweeping (result of reverse measurement), and a result of averaging of the results of the forward measurement and the reverse measurement. Also, the forward measurement and the reverse measurement in Examples 11 and 12 teach that the hysteresis was suppressed.

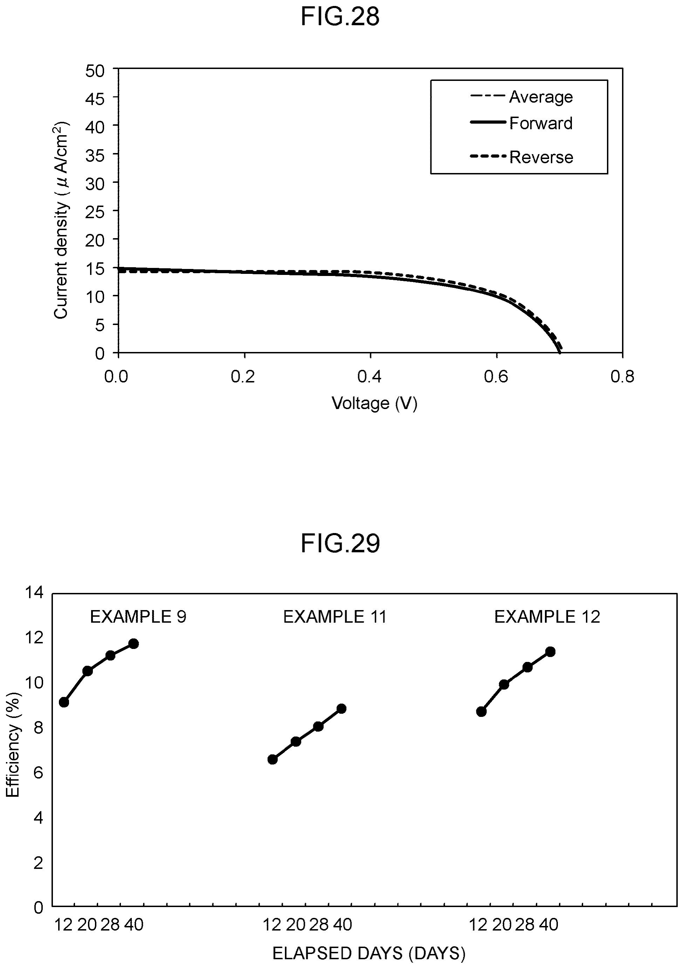

FIG. 29 is a diagram illustrating changes over time in conversion efficiency of the photoelectric conversion element 1 in Example 9, the photoelectric conversion element in Example 11, and the photoelectric conversion element in Example 12. FIG. 29 is a diagram plotting the conversion efficiency, obtained by measuring current-voltage characteristic 12 days after, 20 days after, 28 days after, and 40 days after the manufacture of the photoelectric conversion element, then by deriving the conversion efficiency from these measured results. Also, the cases with the Bi layer/Cr layer/Pt layer and the Bi layer/Cr layer/C layer were found to stably generate electric power, similarly to the case with the Bi layer/Cr layer/Au layer, even 12 days after, 20 days after, 28 days after, and 40 days after. The photoelectric conversion elements in Examples 11 and 12 were found to stably generate electric power, even one day after the manufacture. This teaches that the photoelectric conversion elements in Examples 11 and 12 are suppressed from causing degradation of the power generation characteristic due to changes over time.

Also replacement of the Cr layer in the Bi layer/Cr layer/Pt layer and the Bi layer/Cr layer/C layer respectively in Examples 11 and 12, with the Ti layer, was found to enable stable power generation over a long period of time.

**Table 1**

| | Structure of Upper Electrode | Figure | Time of Measurement | Conversion Efficiency(%) | | |
|---|---|---|---|---|---|---|
| | | | | Average | Forward Measurement | Reverse measurement |
| Comparative Example 1 | Ti layer (2nm)/Au layer (70nm) | FIG. 5A | 7 days after | 4.3 | 3.8 | 4.9 |
| | | FIG. 5B | 15 days after | 1.9 | 1.7 | 2.1 |
| Comparative Example 2 | Ti layer (20nm)/Au layer (52nm) | FIG. 6 | 22 days after | 1.5 | 1.3 | 1.7 |
| Comparative Example 3 | Ti layer (70nm)/Au layer (2nm) | FIG. 7 | 22 days after | 0.3 | 0.3 | 0.3 |
| Comparative Example 4 | Bi layer (72nm) | FIG. 12A | 1 day after | 8.5 | 6.7 | 10.7 |
| Comparative Example 5 | Bi layer (70nm) | FIG. 25A | 1 day after | 10.7 | 10.4 | 11.1 |
| Reference Example 1 | Cr layer (2nm)/Au layer (70nm) | FIG. 19 | 7 days after | 1.5 | 1.3 | 1.7 |
| Reference Example 2 | Bi layer (2m)/Au layer (70nm) | FIG. 8 | 8 days after | 3.7 | 2.8 | 4.9 |
| Reference Example 3 | Bi layer (10nm)/Au layer (62nm) | FIG. 9 | 14 days after | 4.4 | 3.7 | 5.3 |
| Reference Example 4 | Bi layer (70nm)/Ti layer (30nm) | FIG. 18A | 2 days after | 10.6 | 9.8 | 11.4 |
| Example 1 | Bi layer (10nm)/Ti layer (2nm)/Au layer (60nm) | FIG. 10 | 2 days after | 7.2 | 5.9 | 8.7 |
| Example 2 | Bi layer (10nm)/Ti layer (10nm)/Au layer (52nm) | FIG. 11A | 2 days after | 8.5 | 7.4 | 9.7 |
| Example 3 | Bi layer (50nm)/Ti layer (10nm)/Au layer (20nm) | FIG. 13 | 13 days after | 12.6 | 12.2 | 12.9 |
| Example 4 | Bi layer (50nm)/Ti layer (20nm)/Au layer (20nm) | FIG. 14 | 13 days after | 11.6 | 11.2 | 12.2 |
| Example 5 | Bi layer (20nm)/Ti layer (10nm)/Au layer (40nm) | FIG. 15 | 8 days after | 9.6 | 9.6 | 9.6 |
| Example 6 | Bi layer (40nm)/Ti layer (10nm)/Au layer (20nm) | FIG. 16 | 8 days after | 11.5 | 11.7 | 11.4 |
| Example 7 | Bi layer (70nm)/Ti layer (10nm)/Au layer (20nm) | FIG. 17 | 13 days after | 11.7 | 10.8 | 12.6 |
| Example 8 | Bi layer (50nm)/Cr layer (10nm)/Au layer (20nm) | FIG. 20 | 8 days after | 10.1 | 9.9 | 10.3 |
| Example 9 | Bi layer (50nm)/Cr layer (20nm)/Au layer (20nm) | FIG. 21 | 15 days after | 11.4 | 11.1 | 11.9 |
| Example 10 | Bi layer (20nm)/Ti layer (10 m)/Au layer (40nm) | FIG. 24A | 8 days after | 10.8 | 11.0 | 10.7 |
| Example 11 | Bi layer (50nm)/Cr layer (20nm)/Pt layer (20nm) | FIG. 27 | 40 days after | 9.0 | 8.7 | 9.4 |
| Example 12 | Bi layer (50nm)/Cr layer (20nm)/C layer (6nm) | FIG. 28 | 40 days after | 11.4 | 11.1 | 11.8 |

In Table 1, the column "Time of Measurement" denotes how many days after the manufacture of the photoelectric conversion element, was the current-voltage characteristic measured.

Examples 2 to 9 employed the Bi layer/Ti layer/Au layer or the Bi layer/Cr layer/Au layer for the upper electrode. These structures are understood to successfully suppress the hysteresis in the forward measurement and the reverse measurement (FIG. 11A, FIGS. 13 to 17, FIG. 20, and FIG. 21).

### Reference Signs List

1, 2 PHOTOELECTRIC CONVERSION ELEMENT
10 TRANSPARENT SUBSTRATE
11 TRANSPARENT ELECTROCONDUCTIVE LAYER
12 HOLE TRANSPORT LAYER
13 LIGHT ABSORPTION LAYER
14 ELECTRON TRANSPORT LAYER
15 UPPER ELECTRODE
151 Bi LAYER
152 Ti LAYER OR Cr LAYER
153 Au LAYER
16 LOWER ELECTRODE
17 CONTACT LAYER

## Claims

1. A photoelectric conversion element comprising:
a transparent electroconductive layer; a hole transport layer; a light absorption layer; an electron transport layer; and an electrode,
wherein the transparent electroconductive layer, the hole transport layer, the light absorption layer, the electron transport layer, and the electrode are stacked in this order,
the light absorption layer contains a material that contains a halide ion,
the electrode has a first electroconductive layer, a second electroconductive layer, and a third electroconductive layer stacked in this order when viewed from the electron transport layer,
the first electroconductive layer is structured to make ohmic contact with the electron transport layer, and prevent the diffusion of the halide ion towards the second electroconductive layer,
the second electroconductive layer is structured to prevent the diffusion of the third electroconductive layer towards the electron transport layer or the light absorption layer, and
the third electroconductive layer is less reactive with oxygen or the halide ion, than the second electroconductive layer is.

2. The photoelectric conversion element according to claim 1, wherein
the third electroconductive layer has a work function of 5.0 eV or larger.

3. The photoelectric conversion element according to claim 1, wherein
the first electroconductive layer contains Bi.

4. The photoelectric conversion element according to claim 1, wherein
the second electroconductive layer contains Ti or Cr.

5. The photoelectric conversion element according to claim 1, wherein
the third electroconductive layer contains Au, Pt, or C.

6. A photoelectric conversion element comprising:
a transparent electroconductive layer; a hole transport layer; a light absorption layer; an electron transport layer, and an electrode,
wherein the transparent electroconductive layer, the hole transport layer, the light absorption layer, the electron transport layer, and the electrode are stacked in this order,
the light absorption layer contains a material that contains a halide ion, and
the electrode has a Bi layer, a Ti layer or a Cr layer, and an Au layer stacked in this order when viewed from the electron transport layer.

7. The photoelectric conversion element according to claim 6, wherein
the material contained in the light absorption layer further contains silver ion and bismuth ion.

8. The photoelectric conversion element according to claim 6 or 7, wherein
the Bi layer has a thickness of 10 nm or larger and 70 nm or smaller.

9. The photoelectric conversion element according to claim 6 or 7, wherein
the Ti layer or the Cr layer has a thickness of 2 nm or larger and 60 nm or smaller.

10. The photoelectric conversion element according to claim 6 or 7, wherein
the Au layer has a thickness of 10 nm or larger and 20 nm or smaller.

11. The photoelectric conversion element according to claim 6 or 7, wherein
the electron transport layer contains fullerene or phenyl-C₆₁-butyric acid methyl ester.

12. The photoelectric conversion element according to claim 1 or 6, further comprising:
a contact layer interposed between the electron transport layer and the electrode, wherein
the contact layer contains bathocuproine.

13. A solar cell comprising the photoelectric conversion element according to claim 1 or 6.
